# EUROPEAN PATENT SPECIFICATION

(11) **EP 4 071 813 B1**
(45) Date of publication and mention of the grant of the patent: **04.02.2026**
(21) Application number: 20895753.0
(22) Date of filing: 01.12.2020
(51) Int. Cl.: H02M 7/5387, H03K 17/12

(54) **SEMICONDUCTOR-CIRCUIT CONTROL METHOD AND ELECTRIC POWER CONVERTER TO WHICH THE SAME IS APPLIED**
VERFAHREN ZUR STEUERUNG EINES HALBLEITERSCHALTKREISES UND ELEKTRISCHER LEISTUNGSWANDLER, BEI DEM ES ANGEWENDET WIRD
PROCÉDÉ DE COMMANDE DE CIRCUIT SEMI-CONDUCTEUR ET CONVERTISSEUR ÉLECTRIQUE DE PUISSANCE AUQUEL IL EST APPLIQUÉ

(30) Priority: 06.12.2019 JP 2019220925
(43) Date of publication of application: 12.10.2022
(73) Proprietor: Hitachi, Ltd., Tokyo 100-8280 (JP)
(72) Inventor: MIYOSHI, Tomoyuki, Tokyo 100-8280 (JP); SUZUKI, Hiroshi, Tokyo 100-8280 (JP)
(74) Representative: Mewburn Ellis LLP
(86) International application number: PCT/JP2020/044661
(87) International publication number: WO 2021/112076

(56) References cited:
- WO-A1-2017/135037
- JP-A- 2012 146 977
- JP-A- 2018 117 044
- JP-A- 2019 149 511
- JP-A- 2019 149 511
- US-A1- 2016 013 299
- US-A1- 2021 057 537

## Description

### Technical Field

The present invention relates to a semiconductor-circuit control method and an electric power conversion apparatus to which the same is applied, and particularly relates to a method of controlling a semiconductor circuit that is preferable for low-power instruments such as an air conditioner and a microwave, and high-power instruments such as an automobile, a train, and an inverter at a steel plant, and relates to an electric power conversion apparatus using the same.

### Background Art

Global warming is a worldwide important and urgent problem, and contribution of a power electronics technology as one of its measures is increasingly expected. In particular, to increase the efficiency of an inverter having an electric power conversion function, reduction of electric power consumption is required for power semiconductor devices such as an insulated gate bipolar transistor (IGBT) and a diode, both included in the inverter, the IGBT providing a power switching function, the diode providing a rectification function.

A gate control diode disclosed in Patent Literature 1 has been known as a technology of mainly reducing a reverse recovery loss at the diode. This includes a structure in which a gate electrode capable of controlling the concentration of carriers injected into a drift area is disposed on the surface of an anode area, and its control technology.

### Citation List

### Patent Literature

Patent Literature 1
Japanese Patent Laid-Open No. 2018-117044

US 2016/013299 discloses a semiconductor device, drive device for semiconductor circuit, and power conversion device

WO 2017/135037 discloses a semiconductor device, method for producing same, and power conversion device using same

### Summary of Invention

### Technical Problem

However, a diode in a paired arm conducts in the durations of various non-conduction commands to an IGBT, and thus a technology capable of minimizing a conduction loss, a reverse recovery loss, and a forward recovery loss by considering operation in various conduction durations and switching modes like the IGBT is required. Thus, with the diode technology disclosed in Patent Literature 1, it is difficult to reduce the forward recovery loss in pulse width modulation (PWM) operation of an inverter.

The present invention is made in view of the above-described problem and intended to provide a semiconductor-circuit control method that can achieve electric power consumption reduction and size reduction as compared to a conventional gate-control-diode control method by reducing a forward recovery loss as well as a conduction loss that occurs to a diode under various pulse conditions in PWM operation of an inverter.

### Solution to Problem

The present invention that solves the above-described problem is a method of controlling a semiconductor circuit as set forth in claim 1.

### Advantageous Effects of Invention

According to the present invention, it is possible to provide a semiconductor-circuit control method that can achieve electric power consumption reduction and size reduction by reducing a forward recovery loss as well as a conduction loss that occurs to a diode under various pulse conditions in PWM operation of an inverter. Problems, configurations, and effects other than those described above will be clarified in the following description of an embodiment.

### Brief Description of Drawings

[Figure 1A] Figure 1A is a timing chart illustrating a gate-control-diode control method (hereinafter also referred to as a "semiconductor-circuit control method", a "control method", or simply a "method") according to an embodiment of the present invention and illustrating a case "a" in which a non-conduction duration t_{off} is long.
[Figure 1B] Figure 1B is a timing chart illustrating a case "c" in which the non-conduction duration t_{off} is shorter as in Figure 1A.
[Figure 2] Figure 2 is a circuit diagram of a PWM inverter to which the method in Figure 1 is applied.
[Figure 3A] Figure 3A has the same content as Figure 1A and is a timing chart illustrating the case "a" in which the non-conduction duration t_{off} is long.
[Figure 3B] Figure 3B is a timing chart illustrating the case "c" in which the non-conduction duration t_{off} is short, for comparison with Figure 3A.
[Figure 4] Figure 4 is a timing chart illustrating the embodiment in Figures 1A and 3A, a comparative example in Figure 3B, a current waveform, a voltage waveform, and a time integral waveform of current-voltage product obtained by each method.
[Figure 5A] Figure 5A is a timing chart for description of operation of the inverter in Figure 2.
[Figure 5B] Figure 5B is a correlation diagram of a loss at a gate control diode in Figure 2 and a carrier extraction time t_{d_rr}, illustrating a case in which the non-conduction duration t_{off} is long.
[Figure 5C] Figure 5C is a correlation diagram illustrating a case in which the non-conduction duration t_{off} is shorter than in Figure 5B.
[Figure 6A] Figure 6A is a timing chart for description of optimum t_{d_rr} that minimizes the loss at the gate control diode in Figure 2.
[Figure 6B] Figure 6B is a correlation diagram of the optimum t_{d_rr} for the gate control diode in Figure 2 and the non-conduction duration t_{off} of IGBTs in paired arms (upper and lower arms).
[Figure 7A] Figure 7A is a schematic diagram illustrating a cross-sectional view of the gate control diode, operation of which is described with reference to Figures 1A and 1B, and carriers at conduction.
[Figure 7B] Figure 7B is a schematic diagram illustrating a cross-sectional view of the gate control diode, operation of which is described with reference to Figures 1A and 1B, and carriers at conduction.
[Figure 8A] Figure 8A is a gate-bias correspondence diagram when a forward recovery voltage at commutation of the gate control diode, operation of which is described with reference to Figures 1A and 1B, is small.
[Figure 8B] Figure 8B is a gate-bias correspondence diagram when the above-described forward recovery voltage is higher than in Figure 8A.
[Figure 9A] Figure 9A is a timing chart illustrating the method according to the embodiment of the present invention and illustrating the case in which the non-conduction duration t_{off} is long.
[Figure 9B] Figure 9B is a timing chart illustrating a case in which the non-conduction duration t_{off} is shorter than in Figure 9A.
[Figure 10] Figure 10 is a circuit diagram illustrating an inverter in which a gate control circuit that achieves the control method in Figures 9A and 9B is coupled to an arm.
[Figure 11A] Figure 11A is a timing chart illustrating a sequence of each signal in the gate control circuit in Figure 10 and illustrating a case in which an "on" command duration is long.
[Figure 11B] Figure 11B illustrates a case in which the "on" command duration is shorter than in Figure 11A.
[Figure 12] Figure 12 is a circuit diagram of an inverter to which the control method in Figures 9A and 9B is applied.
[Figure 13] Figure 13 is a timing chart illustrating gate waveforms and main circuit waveforms of IGBTs and gate control diodes in paired arms (upper and lower arms) at regeneration operation of the inverter in Figure 12.
[Figure 14] Figure 14 is a diagram illustrating gate waveforms and main circuit waveforms of IGBTs and gate control diodes in paired arms (upper and lower arms) at powering operation of the inverter in Figure 12.
[Figure 15] Figure 15 is a circuit diagram illustrating an inverter in which a gate control circuit that achieves the method according to the embodiment of the present invention is coupled to an arm.
[Figure 16] Figure 16 is a timing chart illustrating a sequence of each signal in the gate control circuit in Figure 15 when a command pulse width is long, in particular.
[Figure 17] Figure 17 is a timing chart illustrating a sequence of each signal in the gate control circuit in Figure 15 when the command pulse width is short, in particular.
[Figure 18] Figure 18 is a circuit diagram of a three-phase alternating-current inverter to which the method according to the embodiment of the present invention is applied.
[Figure 19] Figure 19 is a circuit diagram of a three-phase alternating-current inverter to which dual-gate IGBTs are applied as a modification of Figure 18.
[Figure 20] Figure 20 is a circuit diagram of a three-phase inverter having an arm-pair configuration.
[Figure 21] Figure 21 is a diagram of an evaluation circuit that evaluates recovery characteristics of a diode assumed for operation of an electric power conversion apparatus configured to generate alternating-current output from a direct-current power source.
[Figure 22] Figure 22 is a timing chart illustrating recovery characteristics obtained by the evaluation circuit in Figure 21.

### Description of Embodiments

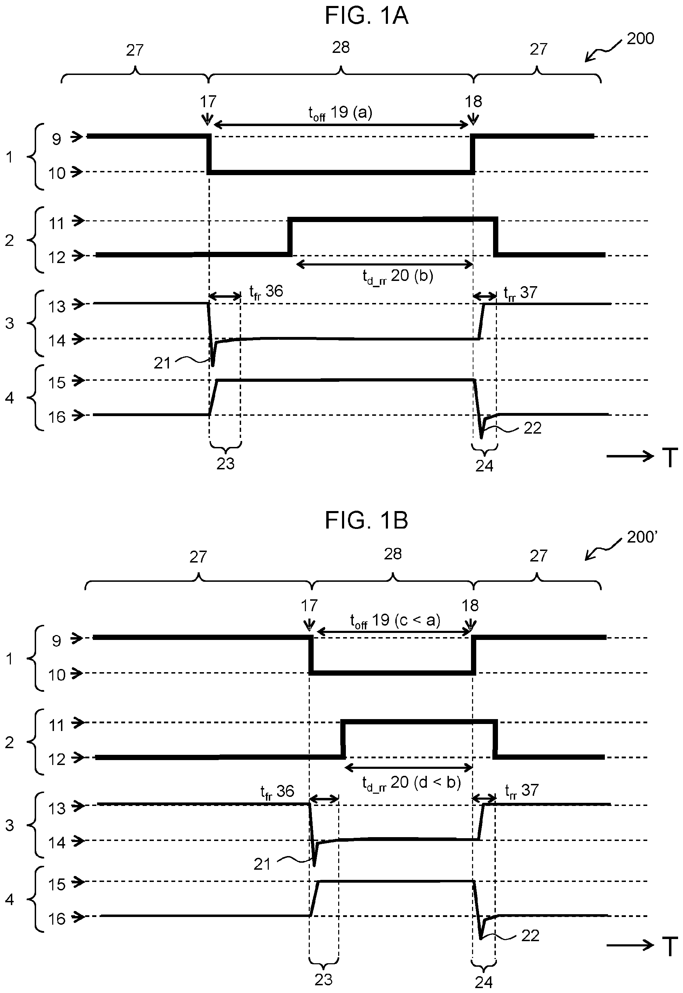

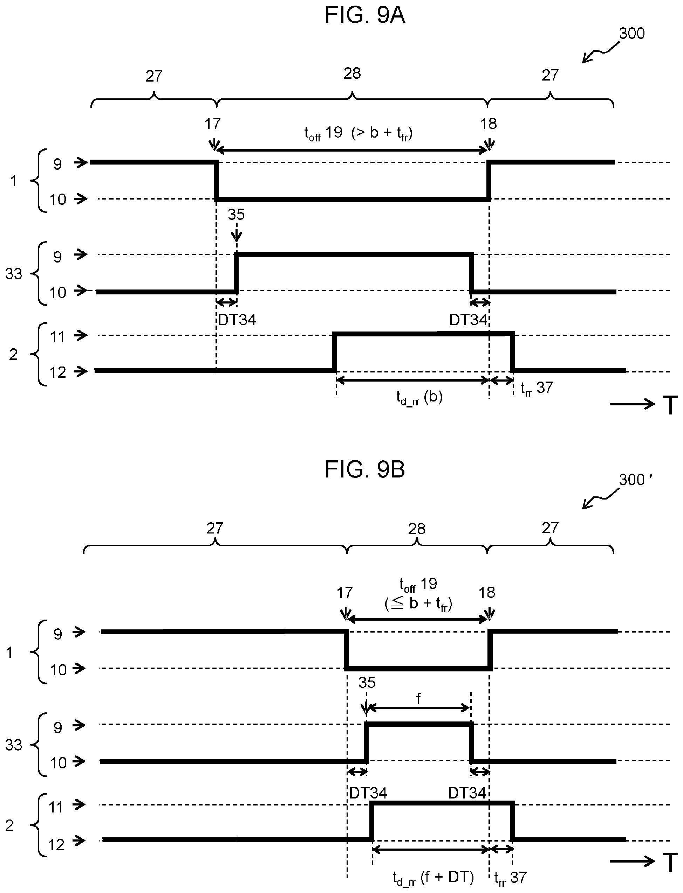

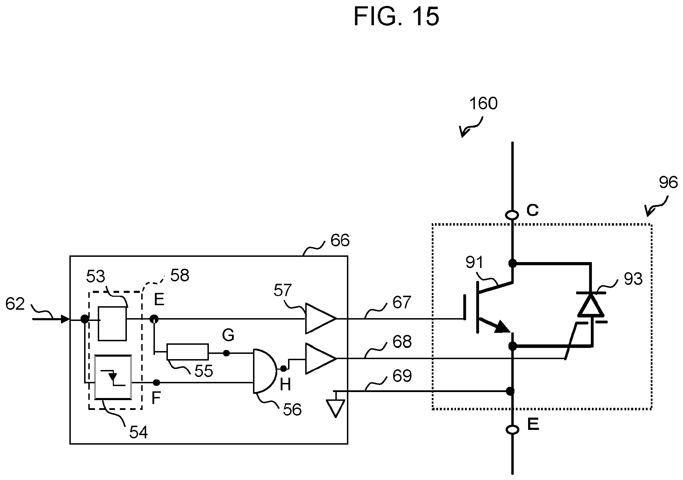

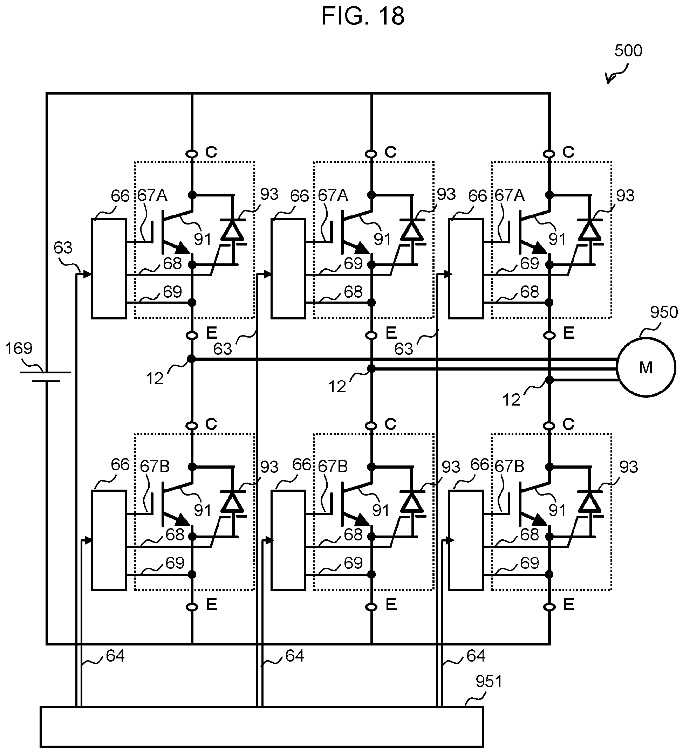

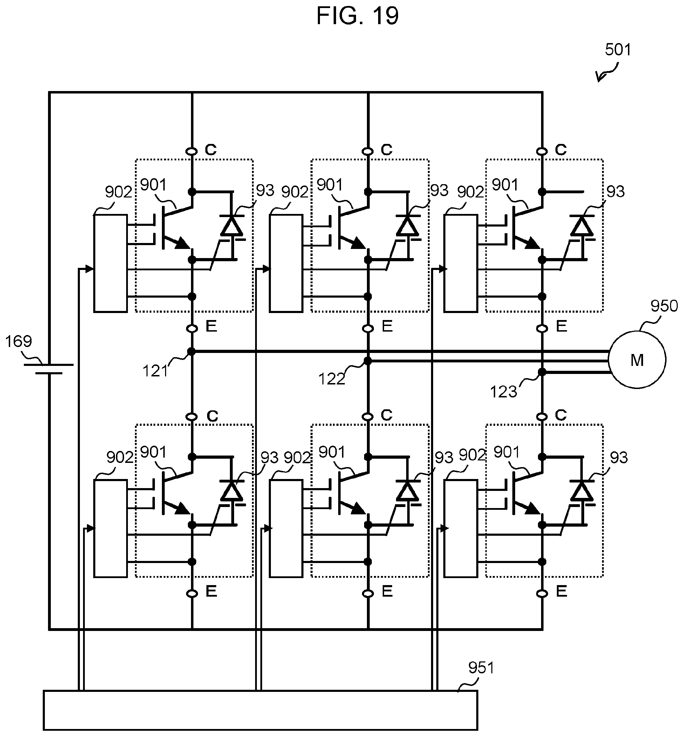

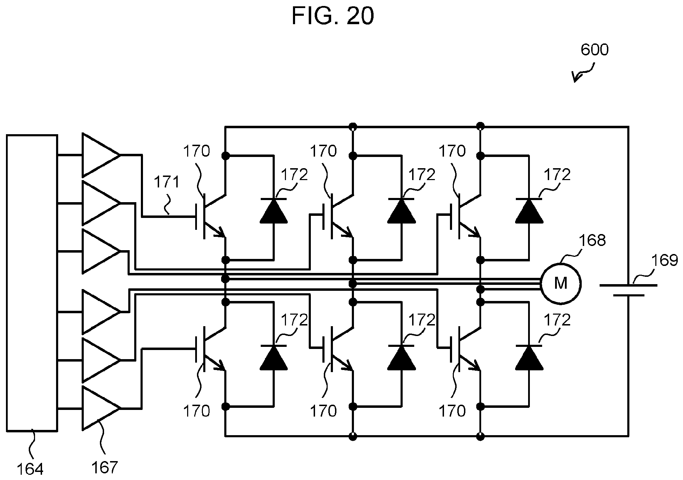

Examples 1 to 4 of the present invention and basic technologies thereof will be described below with reference to the accompanying drawings. Example 1 will be described with reference to Figures 1A to 8B, Example 2 will be described with reference to Figures 9A to 14, Example 3 will be described with reference to Figures 15 to 17, Example 4 will be described with reference to Figure 18, and a modification of Example 4 will be described with reference to Figure 19. In addition, basic technologies and a comparative example of the present invention will be described with reference to Figures 20 to 22.

Note that, in a circuit diagram of each drawing, an electrical conduction line that transfers a gate signal is illustrated as one line for a gate terminal in a simplified manner. As for this point, emitter potential is used as a reference in reality, and thus there is a reference electrical conduction line and voltage is input with respect to the reference potential. In a circuit diagram of each drawing, illustration of the reference electrical conduction line that conducts with the emitter of a dual-gate IGBT is omitted.

### [Example 1]

A gate-control-diode control method (semiconductor-circuit control method) according to Example 1 of the present invention is defined with timing charts 200 and 200' in Figures 1A and 1B. In other words, the method of Example 1 is a method illustrated in the timing charts 200 and 200' in Figures 1A and 1B. Figure 1A illustrates a case "a" in which a non-conduction duration t_{off} 19 is long. Hereinafter, the horizontal axis in a timing chart such as Figure 1A represents the same time T.

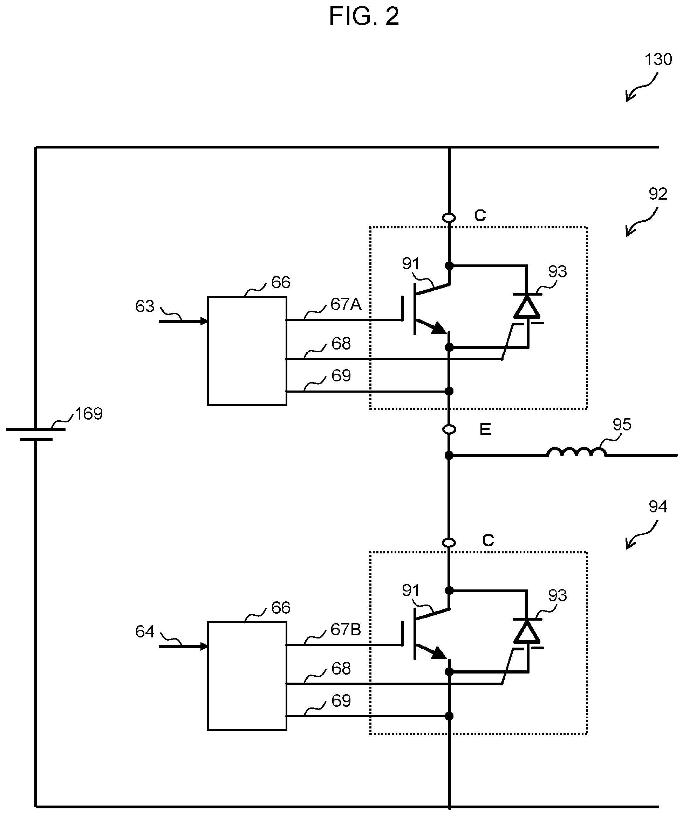

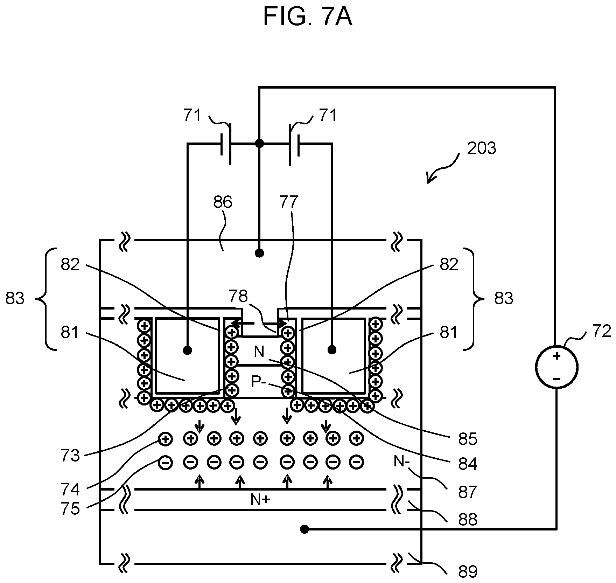

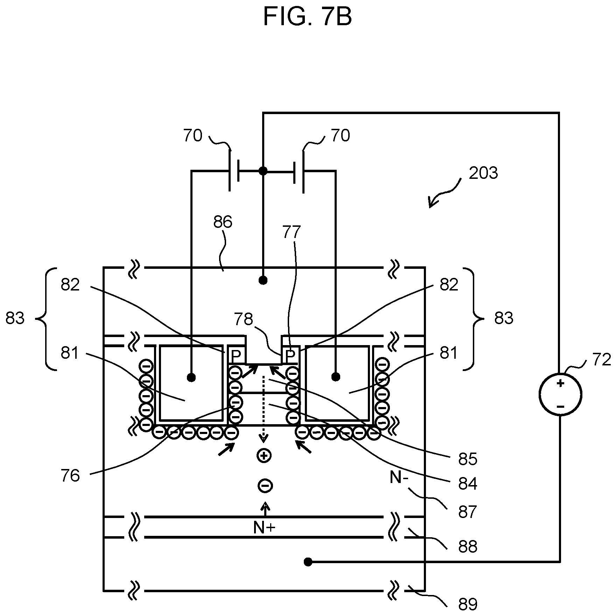

Figure 1B illustrates a case "c" in which the non-conduction duration t_{off} 19 is shorter as in Figure 1A. The timing chart 200, 200' in Figures 1A and 1B illustrates gate control signal waveforms 1 and 2 of gate control diodes 93 (Figure 2) and 203 (Figures 7A and 7B), a cathode-anode voltage V_{KA} 3, and a current waveform I_{K} 4.

Figure 2 is a circuit diagram of a PWM inverter 130 to which the method in Figure 1 is applied. As illustrated in Figure 2, in the PWM inverter 130 (hereinafter also simply referred to as an "inverter 130"), two IGBTs 91 coupled in series and the gate control diodes 93 coupled in antiparallel to the respective IGBTs 91 are coupled to a direct-current power source 169, thereby forming paired arms 92 and 94 of an arm 92 and an arm 94.

An inductive load 95 is coupled to a neutral point 90 through which the IGBTs 91 of the respective paired arms 92 and 94 are coupled in series. The two IGBTs 91 (hereinafter also referred to as "paired-arm IGBTs") disposed in the paired arms 92 and 94 perform switching operation under control of PWM command signals 63 and 64 having complementary conduction sequences. As a result, direct-current power 169 is converted into alternating-current power at the inductive load 95. Note that a paired-arm IGBT viewed from the own arm means an IGBT belonging to the other arm viewed from one arm in the paired arms.

In other words, the method of Example 1 is a control method of applying a bias voltage to the gate of a gate control diode having a function to control carrier concentration of a drift area. The single-phase PWM inverter 130 illustrated in Figure 2 is an exemplarily inverter to which the method is applied. The inverter 130 has a circuit configuration including the IGBTs 91 disposed in the respective paired arms 92 and 94 and the diodes 93 coupled in antiparallel to the respective IGBTs 91.

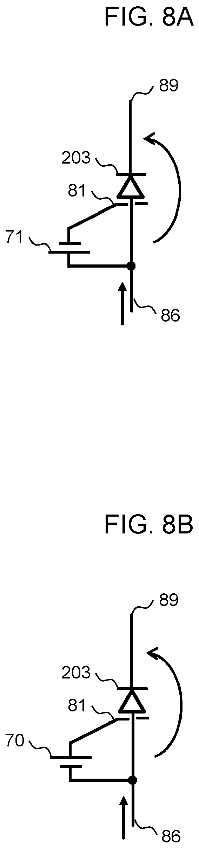

Antiparallel coupling means a circuit form of parallel coupling in each of the arms 92 and 94 illustrated in Figure 2, in which a conduction direction through the collector and emitter of the IGBT 91 is opposite a conduction direction through (Figures 7A, 7B, 8A, and 8B) an anode 86 and a cathode 89 of the gate control diode (hereinafter also simply referred to as a "diode") 93. Note that "anode" and "cathode" are referred to as "anode electrode" and "cathode electrode" in accordance with the situation of description.

Note that both gate terminals of the IGBTs 91 disposed in the respective paired arms 92 and 94 are collectively referred to as gate terminals 67. When needed, a gate terminal 67A of the IGBT 91 disposed in the upper arm 92 and a gate terminal 67B of the IGBT 91 disposed in the lower arm 94 are distinguished from each other by different reference signs.

In the inverter 130, upon an "off" command of the IGBT 91 disposed in the one arm 92, current is commutated into the diode 93 disposed in the same arm 92, and accordingly, the diode 93 becomes the conduction state. Upon an "on" command of the IGBT 91, the IGBT 91 becomes the conduction state, and the diode 93 disposed in the same arm becomes the non-conduction state.

In Figures 1A and 1B, upon turn-off 17 of the gate control signal 1 of the IGBT 91 (paired-arm IGBT) of each of the paired arms 92 and 94, current is commutated into the diode 93, V_{KA} 3 decreases, and I_{K} 4 increases. Typically, an inductive load of an inverter acts for continuation of constant current flow, and thus the same load current as for conduction of the IGBT 91 flows through the diode 93. Accordingly, in the diode 93, a high negative forward recovery voltage V_{KA} 21 is transiently generated for conduction of carriers that flows load current 15 into a drift area 87 (Figures 7A and 7B).

This state is referred to as a forward recovery state 23 and needs a forward recovery duration t_{fr} 36 in which the conduction state becomes stable. In the forward recovery duration t_{fr} 36, a forward recovery loss is generated by the product of transitory changes of V_{KA} and I_{K}. In the gate control diode 93, the gate control signal 2 is biased to a negative voltage 12 lower than a threshold voltage in the forward recovery state 23, thereby increasing the concentration of injected carriers and reducing V_{KA} increase.

Accordingly, the feature of reduction of the forward recovery loss is obtained. Subsequently, the diode 93 becomes a conduction state 28, but a low conduction loss can be obtained by maintaining a negative bias 12. Thereafter, upon turn-on 18 of the gate control signal 1 of the IGBT 91 of the same arm 92, the current I_{K} 4 in the diode 93 is attenuated and commutated into the IGBT 91 of the same arm 92. Then, V_{KA} 3 increases to a power voltage 13 of the inverter 130 and a non-conduction state 27 is reached.

Reverse recovery current 22 as current in the opposite direction flows through the diode 93 as remaining carriers that contribute to conductivity modulation at conduction return to the anode 86, and a reverse recovery duration tᵣᵣ 37 in which the non-conduction state 27 is reached is needed. This state is referred to as a reverse recovery state 24, and a reverse recovery loss is generated by the product of transitory changes of V_{KA} and I_{K}.

The gate control diode 93 controls the gate control signal 2 to apply zero bias or positive bias 11 in a carrier extraction duration t_{d_rr} 20 right before the reverse recovery state 24. With this control, the concentration of carriers injected from the anode can be reduced, and electron carriers that contribute to conductivity modulation can be discharged to the anode. As a result, the carrier concentration of the drift area can be temporarily reduced, and the reverse recovery current 22 can be reduced in the reverse recovery state 24. Accordingly, the feature of a low reverse recovery loss is obtained.

Since an alternating-current waveform is generated through PWM operation at the inverter 130, operation of the IGBTs 91 and the diodes 93 in various conduction and non-conduction widths needs to be considered. In particular, each diode 93 in the inverter 130 conducts in a duration in which the IGBT 91 in the same arm is off. Accordingly, the forward recovery state, the conduction state, and the reverse recovery state occur to the diode 93 at timings of turn-off and turn-on of the IGBT 91 in the same arm. Thus, gate bias applied to the gate control diode 93 at the timings is important for derivation of a loss reduction effect in the inverter 130.

As described above, Figures 1A and 1B illustrate the gate control signal 2 of each gate control diode 93 with which the forward recovery loss, the conduction loss, and the reverse recovery loss at the diode 93 can be all reduced in the case "a" in which the non-conduction duration t_{off} 19 of the IGBT 91 in the same arm is long and the case "c" in which the non-conduction duration t_{off} 19 of the IGBT 91 in the same arm is short. In the forward recovery state 23, the gate bias is the negative bias 12 lower than the threshold voltage.

The carrier concentration of the gate control diode 93 can be optimized through a sequence of applying the zero bias or positive bias 11 as the gate bias in the reverse recovery state 24. When the PWM operation of the inverter 130 is considered, the loss reduction effect at the diode 93 can be derived at the PWM inverter 130 by controlling the carrier extraction duration t_{d_rr} 20 to vary in accordance with the "off" command duration t_{off} 19 of the IGBT 91 in the same arm so that a relation [t_{off} ≥ t_{d_rr} + t_{fr}] is satisfied.

The gate terminal 67 of each IGBT 91, a gate terminal 68 of the corresponding gate control diode, and an emitter sense terminal (hereinafter also referred to as an "emitter electrode") 69 for the reference potential are coupled to a gate control circuit board (hereinafter also referred to as a "gate control circuit") 66. In the gate control circuit 66, a gate control signal that enables the PWM operation of the IGBT 91 and loss reduction at the diode is generated upon reception of the command signals 63 and 64. This gate control signal of the gate control diode 93 is a signal with which t_{d_rr} is controlled to vary in accordance with the "off" duration of the paired-arm IGBT. As a result, an electric power loss that occurs at the diode 93 during the PWM operation of the inverter 130 is minimized.

In such a gate control diode 93, when an "off" command voltage is applied between the gate electrode 67 and the emitter electrode 69 of the IGBT 91 in the non-conduction state, current conducting through the IGBT 91 is commutated and the state becomes the forward recovery state. On the other hand, in the gate control diode 93, when an "on" command voltage is applied between the gate electrode 67 and the emitter electrode 69 of the IGBT 91 in the conduction state, conducting current is commutated to the IGBT 91 and the state becomes the reverse recovery state.

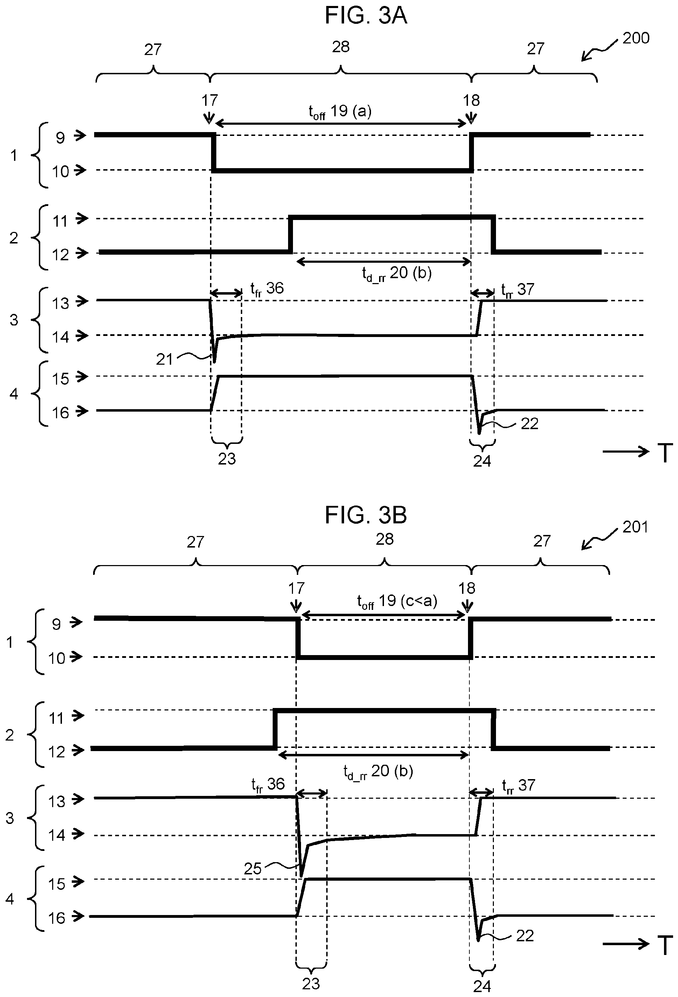

Figure 3A has the same content as Figure 1A and is a timing chart illustrating the case "a" in which the non-conduction duration t_{off} is long. Figure 3A is a timing chart illustrating a method according to the comparative example of the present invention. Figure 3B is a timing chart illustrating the case "c" in which the non-conduction duration t_{off} is short, for comparison with Figure 3A. In other words, Figure 3B illustrates, as a comparative example of the method of Example 1, a control waveform when t_{d_rr} of each gate control diode is fixed and the waveforms of obtained V_{KA} 3 and I_{K} 4. Note that, in the following description, obvious reference signs are omitted from the inverter and its constituent components in some cases instead of prioritizing reference signs provided to a graph such as a timing chart.

Figures 3A and 3B illustrate the gate control signal 1 of the paired-arm IGBT, the gate control signal 2 of the gate control diode, the cathode-anode voltage (V_{KA}) waveform 3 of the gate control diode, the current (I_{K}) waveform 4 of the gate control diode, the time integral of the product of V_{KA} and I_{K} of the gate control diode, in other words, generated energy E_{fr} 5, an "on" voltage 9, an "off" voltage 10, the zero bias or positive bias 11, the negative bias 12 lower than the threshold voltage, a high voltage (power voltage) 13, a 0V potential 14, high current (load current) 15, and a 0A potential 16.

The forward recovery loss increases when the gate control signal 2 having t_{d_rr} at a fixed value b with which the forward recovery loss, the conduction loss, and the reverse recovery loss can be reduced in the case "a" in which the "off" duration of the paired-arm IGBT is long is also applied to the case "c" in which the "off" duration of the paired-arm IGBT is short, in other words, when the relation [t_{off} ≥ t_{d_rr} + t_{fr}] is not satisfied. This is because commutation from the paired-arm IGBT to the diode occurs with the gate bias of the gate control diode at the zero bias or positive bias, and thus the efficiency of carrier injection is low and a large negative V_{KA} 25 transiently occurs.

In the PWM operation of an inverter, the non-conduction duration of an IGBT in paired-arm disposition modulates in various manners against a diode, and thus the forward recovery loss increases unless the gate bias of the gate control diode is negatively biased to a voltage lower than the threshold voltage at the turn-off timing to form a state in which the efficiency of carrier injection is high.

Furthermore, to reduce the reverse recovery loss at reverse recovery, the efficiency of carrier injection needs to be reduced through zero biasing or positive biasing of the gate of the gate control diode at the turn-on timing of the paired-arm IGBT.

Thus, control of t_{d_rr} as the duration of zero biasing or positive biasing of the gate to vary in accordance with the non-conduction duration of the paired-arm IGBT is needed to reduce both the forward recovery loss and the reverse recovery loss that occur to the diode in the PWM operation of the inverter.

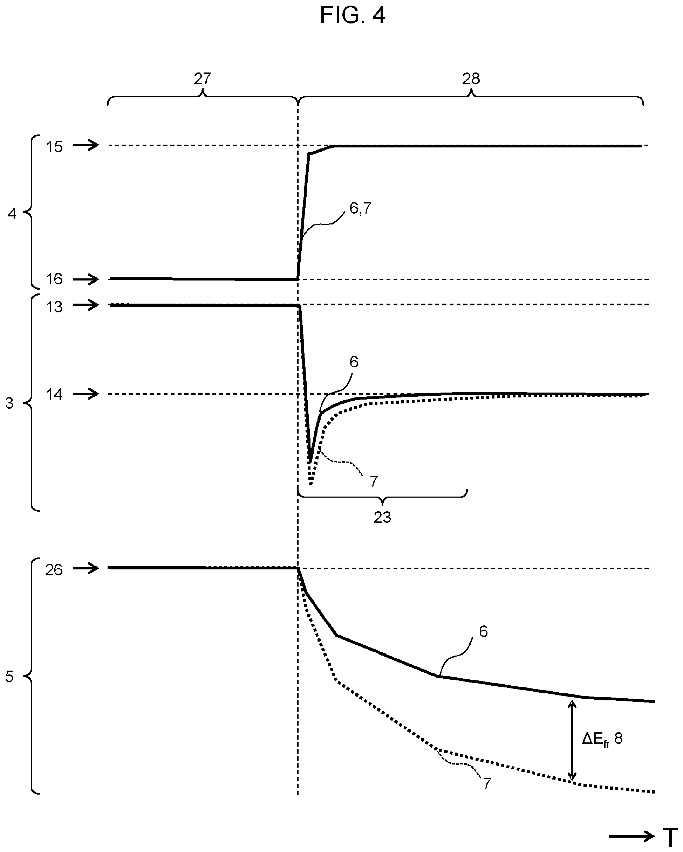

Effects of the method of Example 1 will be described below with reference to Figures 4 to 6B. Figure 4 is a timing chart illustrating Example 1 in Figures 1A and 3A, the comparative example in Figure 3B, and a current waveform, a voltage waveform, and a time integral waveform of current-voltage product obtained by each method. Figure 4 clearly illustrates difference between control 6 of Example 1 with a solid line and control 7 of the comparative example with a dashed line.

Specifically, Figure 4 illustrates the I_{K} waveform 4 and the V_{KA} waveform 3 at forward recovery of the gate control diode, and the generated energy E_{fr} 5 calculated through time integral of current-voltage product. The comparative example is a case in which the duration t_{d_rr} of the gate control signal of the gate control diode is a fixed width and the "off" duration of the paired-arm IGBT is shorter than t_{d_rr}.

The I_{K} waveform 4 of the gate control diode, which is transiently increases due to commutation of the paired-arm IGBT, has no difference nor change between the control 6 of Example 1 illustrated in Figures 1A and 3A and the control 7 of the comparative example illustrated in Figure 3B due to behavior of the inductive load of the inverter. However, in the V_{KA} waveform 3, the control 6 of Example 1 has an effect of reducing voltage increase due to forward recovery of the diode as compared to the control 7 of the comparative example.

This effect is also obtained when t_{d_rr} is controlled by the control 6 of Example 1 to vary in accordance with the "off" duration of the paired-arm IGBT and the "off" duration thereof is short. In other words, the effect is achieved because the efficiency of carrier injection can be increased through application of the negative bias equal to or lower than the threshold voltage to the gate of the gate control diode in the forward recovery state 23 of Example 1.

In this manner, the product of current and voltage applied to the gate control diode decreases due to reduction of transitory forward recovery voltage. As a result, the control 6 of Example 1 is smaller than the control 7 of the comparative example in the generated energy E_{fr} 5 at forward recovery, thereby achieving highly efficient inverter operation.

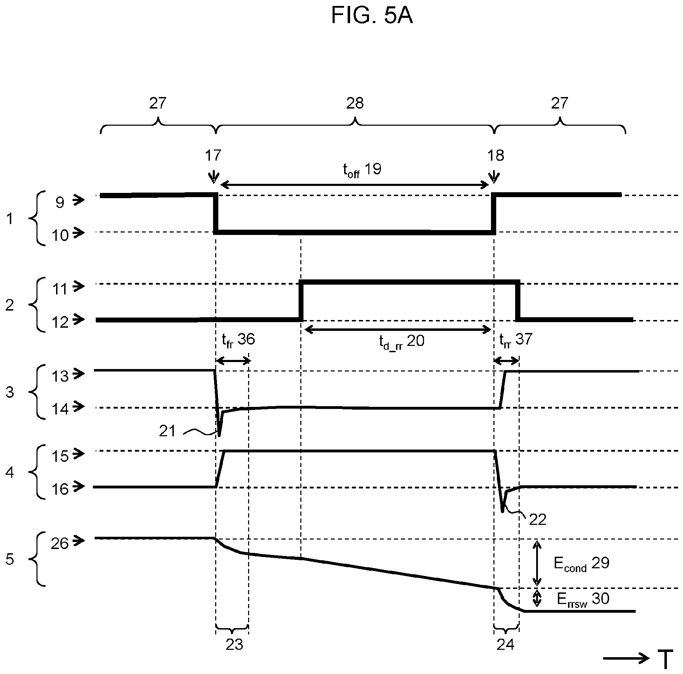

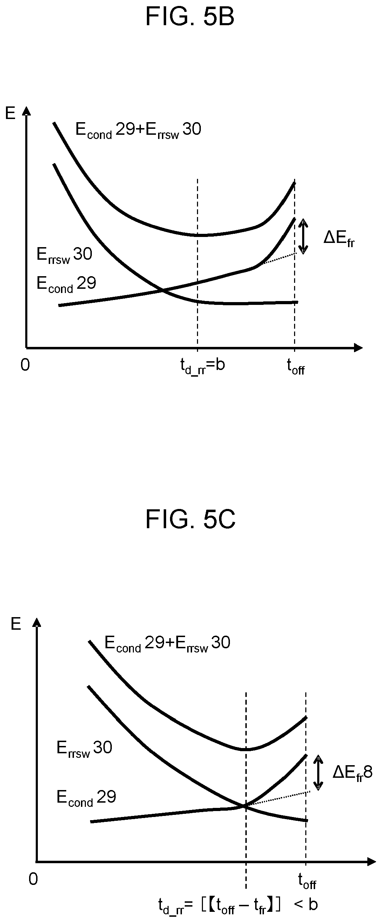

Figure 5A is a timing chart for description of the operation of the inverter 130 in Figure 2. Figure 5B is a correlation diagram of a loss at each gate control diode 93 in Figure 2 and the carrier extraction time t_{d_rr}, illustrating a case in which the non-conduction duration t_{off} is large. Figure 5C is a correlation diagram illustrating a case in which the non-conduction duration t_{off} is shorter than in Figure 5B. In Figures 5B and 5C, the horizontal axis is a time axis that associates the optimum carrier extraction time t_{d_rr} with the non-conduction duration t_{off}, and the vertical axis represents a diode loss E.

Figures 5A to 5C illustrate an occurrence sequence of the forward recovery loss, the conduction loss, and the reverse recovery loss that occur at the diode in the inverter operation, and the correlation between loss and t_{d_rr} in control of the gate control diode. Upon the turn-off 17 of the IGBT with an "off" command input to the gate control signal 1 of the paired-arm IGBT, the gate control diode reaches the conduction state 28 through the forward recovery state 23.

Subsequently, upon the turn-on 18 of the IGBT with an "on" command input to the gate control signal 1 of the paired-arm IGBT, the gate control diode reaches the non-conduction state 27 through the reverse recovery state 24. In this sequence, the generated energy 5 is calculated through time integral of the product of the current I_{K} 4 conducting to the diode and the cathode-anode voltage V_{KA} 3.

To clarify effects of the method of Example 1, the generated energy 5 is divided into a loss E_{cond} 29 generated in the conduction state 28 through the forward recovery state and a loss E_{rrsw} 30 generated in the reverse recovery state 24. In addition, loss increase due to temporary increase of forward-direction voltage in the duration t_{d_rr} 20 in which the zero bias or positive bias is applied to the gate of the gate control diode 92 right before reverse recovery to reduce carrier concentration is taken into consideration and included in E_{cond} 29.

As illustrated in Figure 5B, when t_{d_rr} 20 is treated as a control parameter under a condition that the "off" duration t_{off} of the paired-arm IGBT 19 is long, the effect of carrier extraction right before reverse recovery is increased by increasing t_{d_rr} 20, and accordingly, E_{rrsw} 30 decreases. However, E_{cond} 29 increases due to increase of the conduction loss in a t_{d_rr} duration 20 right before reverse recovery.

Thus, there exists the optimum t_{d_rr} that minimizes the total loss E_{cond} 29 + E_{rrsw} 30 that occurs to the diode. The loss has a constant value in accordance with the structure of the diode in the duration in which t_{off} 19 is long, and can be minimized with the fixed value b. The structure of the diode includes the thickness of the drift area and the lifetime of carriers.

On the other hand, as illustrated in Figure 5C, when t_{d_rr} 20 is increased under a condition that t_{off} is short, particularly, under a condition that t_{off} is shorter than the fixed value b, an increase amount ΔE_{fr} of the forward recovery loss occupies a large part of the conduction loss E_{cond} 29 and the total loss E_{cond} 29 + E_{rrsw} 30 increases. In other words, a loss E at the diode most decreases under a condition that no increase of ΔE_{fr} 8 occurs, and the loss E at the diode can be most decreased by controlling, against the forward recovery duration t_{fr} 36, t_{d_rr} in the duration of a variable value [t_{off} - t_{fr}].

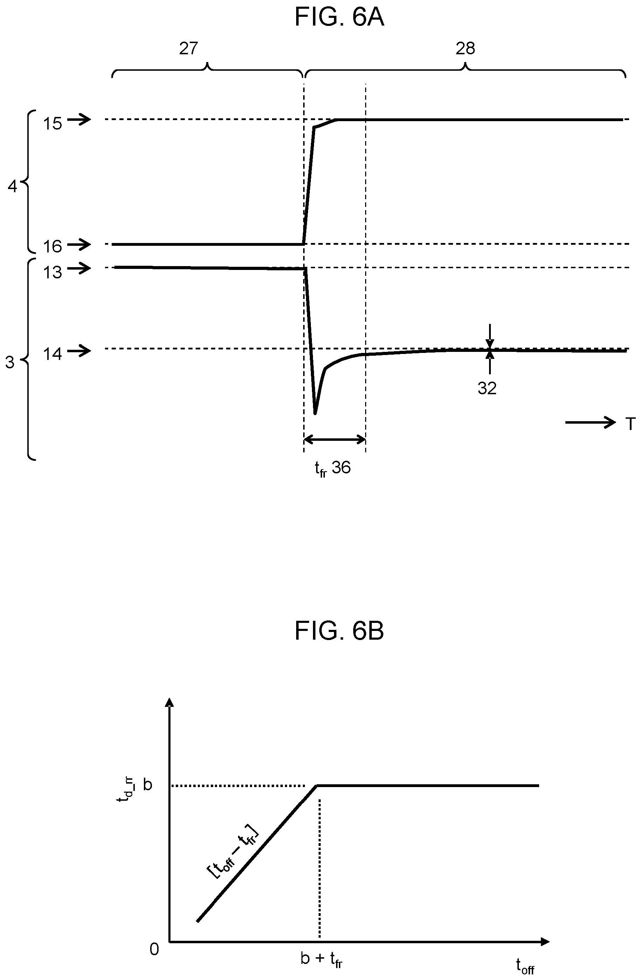

Figure 6A is a timing chart for description of the optimum t_{d_rr} that minimizes the loss at the gate control diode 93 in Figure 2. Figure 6B is a correlation diagram of the optimum t_{d_rr} for the gate control diode 93 in Figure 2 and the non-conduction duration t_{off} of the paired-arm IGBT. In Figure 6B, the vertical axis and the horizontal axis are both time axes.

The forward recovery duration t_{fr} 36 is defined with current 4 and V_{KA} 3 of the diode with reference to Figures 6A and 6B, and the optimum t_{d_rr} that minimizes the loss at the diode by the method of Example 1 will be described below. In Figures 6A and 6B, after commutation starts and the current 4 of the diode starts increasing at forward recovery, V_{KA} is inverted to have a maximum value upon application of voltage with which carriers are injected, and then, upon carrier filling, V_{KA} is stabilized at a forward-direction voltage 32 and the current I_{K} is stabilized at the load current 15 of the paired-arm IGBT.

The change amount ΔE_{fr} of the forward recovery loss, which can be controlled with the gate bias of the gate control diode is a change between time points before and after the negative V_{KA} takes a maximum value after commutation starts, and thus the forward recovery duration t_{fr} 36 is defined to be a duration until current is stabilized after the commutation start, and the optimum control condition t_{d_rr} with t_{fr} 36 taken into account exists.

The loss at the diode can be most reduced by setting the fixed value b to t_{d_rr} when the "off" duration t_{off} of the paired-arm IGBT, in other words, a gate control diode conduction duration is longer than the fixed value b + t_{fr}, which is determined by the structure of the diode. On the other hand, the loss at the diode can be most reduced by setting the variable value [t_{off} - t_{fr}] to t_{d_rr} so that the forward recovery loss does not increase, when t_{off} is shorter than the fixed value b + t_{fr}.

As described above, according to the method of Example 1, the loss at the gate control diode during the PWM operation of the inverter can be minimized by controlling the duration t_{d_rr} to vary in accordance with the non-conduction duration of the paired-arm IGBT, in other words, the diode conduction duration.

According to the method of Example 1, even when the turn-off timing of the paired-arm IGBT changes due to the PWM operation of the inverter, the efficiency of carrier injection can be constantly increased in the forward recovery state with commutation to the gate control diode. As a result, transitory increase of the anode-cathode voltage can be reduced, and the forward recovery loss at the diode can be reduced.

Moreover, right before the reverse recovery state is reached, carrier concentration can be temporarily reduced by controlling the gate bias, and thus a low conduction loss and a low reverse recovery loss can be both achieved.

Subsequently, the reason why the effects of Example 1 are obtained will be described below with reference to Figures 7A to 8. Figure 7A is a schematic diagram illustrating a cross-sectional view of the gate control diode 203, operation of which is described with reference to Figures 1A and 1B, and carriers at conduction.

Figure 7B is a cross-sectional view of the gate control diode 203 in Figure 7A and is a schematic diagram of carriers in conduction when a negative voltage 71 lower than the threshold voltage and a zero bias or positive bias 70 are applied to the gate.

The gate control diode 203 illustrated in Figures 7A and 7B includes an N-type cathode drift layer 87, a P-type anode layer 84 adjacent to the N-type cathode drift layer 87 in the longitudinal direction, and an N+ cathode layer 88 adjacent to the N-type cathode drift layer 87 in the longitudinal direction on a side opposite the P-type anode layer 84. Note that a site may be described in different expressions such as "layer", "area", and "electrode" or omitted in accordance with the situation of description within a range that is obvious for the skilled person in the art.

In addition, an N-type well layer 85 is adjacent on the P-type anode layer 84, and a P-type anode layer 77 exists above the N-type well layer 85. The P-type anode layer 84, the N-type well layer 85, and the P-type anode layer 77 contact a trench-gate insulation gate (also simply referred to as a "gate") 83 including a gate electrode 81 through a gate insulating film (gate oxide film) 82.

Accordingly, an anode area includes the P-type anode layer 84, the N-type well layer 85, and the P-type anode layer 77 sequentially from the lower layer to the upper layer. The anode electrode 86 has a trench shape that is convex downward, contacts the P-type anode layer 77 and the N-type well layer 85, and is electrically separated from the P-type anode layer 84 through the N-type well layer 85.

The anode electrode 86 is electrically coupled to the P-type anode layer 77 through a Schottky or ohmic contact (barrier) 78, and the cathode electrode 89 is electrically coupled to the N+ cathode layer 88 through a ohmic contact. Note that each semiconductor layer used here is made of silicon (Si) or silicon carbide (SiC), and the gate insulating film 82 is made of silicon dioxide (SiO₂).

Specifically, the anode electrode 86 has a convex shape from the upper layer to the lower layer and is formed so that a position contacting the P-type anode layer 77 is on the upper layer side of a position contacting the N-type well layer 85. The N-type well layer 85 and the P-type anode layer 77 are both electrically coupled to the anode electrode 86 and electrically separated from a semiconductor substrate. However, the N-type well layer 85 may have a low concentration, and the anode electrode 86 and the P-type anode layer 84 may partially or entirely contact.

In the structure of the gate control diode 203 (hereinafter also referred to as "the structure of the diode 203") illustrated in Figures 7A and 7B, a hole layer 73 is generated at the interface of the gate oxide film 82 by applying, to the gate electrode 81, a negative bias 71 lower than a threshold voltage with which an electron layer is generated in the P-type anode layer 84 and the N-type well layer 85.

In this state, when forward-direction current from a forward-direction external power source 72 conducts between the anode electrode 86 and the cathode electrode 89, hole carriers 74 are injected at a high concentration from the anode electrode 86 into the N-type cathode drift layer 87 through the hole layer 73 and conductivity modulation is caused by electron carriers 75 injected from the cathode electrode 89, and accordingly, the feature of a low forward-direction voltage is obtained.

On the other hand, in the structure of the diode 203, an electron layer 76 is generated at the interface of the gate oxide film 82 by applying, to the gate electrode 81, the zero bias or positive bias 70 with which an electron layer is generated in the P-type anode layer 84 and the N-type well layer 85.

In this state, when forward-direction current conducts between the anode electrode 86 and the cathode electrode 89 from the external power source 72, electron carriers in the N-type cathode drift layer 87 are discharged into the anode electrode 86 through the electron layer 76 generated at the interface of the gate oxide film 82, and the carrier concentration of the N-type cathode drift layer 87 decreases.

Hole carriers injected from the anode electrode 86 are injected at a low concentration into the N-type cathode drift layer 87 in an area directly below the anode electrode 86 and separated from the gate oxide film 82. In this case, a high voltage that exceeds the barrier of injection is applied. As a result, forward-direction voltage applied to the anode electrode 86 and the cathode electrode 89 increases.

The forward recovery state of the gate control diode during the inverter operation will be described below based on state change of the diode 203 by the gate bias with reference to Figures 8A and 8B. Figure 8A is a gate-bias correspondence diagram when forward recovery voltage (transient voltage) at commutation (arrow) of the gate control diode, operation of which is described with reference to Figures 1A and 1B is low.

Figure 8B is a gate-bias correspondence diagram when the above-described forward recovery voltage is higher than in Figure 8A. As illustrated in Figures 8A and 8B, the efficiency of hole carrier injection from the anode electrode 86 at commutation through the diode is high in a state in which the negative bias 71 lower than the threshold voltage is applied to the gate electrode 81. Accordingly, the forward recovery voltage that is transiently applied to cause conductivity modulation in the N-type cathode drift layer 87 is low.

On the other hand, in a state in which the zero bias or positive bias 70 is applied to the gate electrode 81, the efficiency of hole carrier injection from the anode electrode 86 at commutation through the diode is low, and accordingly, the forward recovery voltage that is transiently applied to cause conductivity modulation in the N-type cathode drift layer is high.

Thus, a control sequence of applying the negative bias 71 lower than the threshold voltage to the gate at commutation through the gate control diode is needed to reduce the forward recovery loss. In addition, the method of Example 1, which controls t_{d_rr} to vary, is effective to reduce both the conduction loss and the reverse recovery loss in the PWM operation of the inverter.

As described above, the forward recovery loss, the conduction loss, and the reverse recovery loss at the gate control diode during the PWM operation of the inverter can be minimized by the semiconductor-circuit control method according to Example 1 of the present invention.

### [Example 2]

A gate-control-diode control method (semiconductor-circuit control method) according to Example 2 of the present invention will be described below with reference to Figures 9A to 14. Figure 9A is a timing chart 300 illustrating the method of Example 2, illustrating a case in which the non-conduction duration t_{off} is long. Figure 9B is a timing chart 300' illustrating a case in which the non-conduction duration t_{off} 19 is shorter than in Figure 9A.

Figures 9A and 9B illustrate a gate control signal waveform 1 of an IGBT in paired-arm disposition, a gate control signal waveform 33 of an IGBT in own-arm disposition, and a gate control signal waveform 2 of a gate control diode in own-arm disposition.

Since a PWM inverter has a function to convert direct-current power into alternating-current power through complementary conduction of two IGBTs disposed in paired arms, a gate control signal of a conduction command is complementarily input to the gates of the IGBTs in paired-arm disposition. In addition, a dead time DT34 is provided in the gate control signal to prevent a short-circuit phenomenon as an operation anomaly that occurs when the paired arms are simultaneously turned on.

The timing of a gate control signal that can minimize a loss at the gate control diode by using the gate control signal of an own-arm IGBT in synchronization with the gate control signal of a paired-arm IGBT, and the gate control circuit 66 that achieves the gate control signal will be described in Example 2. Figure 9A illustrates the gate control signal in a case in which the non-conduction duration t_{off} of the paired-arm IGBT is long, in other words, a case in which the conduction duration of the own-arm diode is long, and Figure 9B illustrates the gate control signal in a case in which the non-conduction duration t_{off} of the paired-arm IGBT is short.

The case in which the duration t_{off} is long is a case in which the duration t_{off} is longer than the sum of a t_{d_rr} duration b and a forward recovery duration t_{fr} in which carriers are extracted by applying a zero bias or positive bias to the gate of the gate control diode, the carrier concentration of the drift area is stabilized, and the reverse recovery loss is minimized.

First, a condition that the duration t_{off} 19 is long will be described below. Under the condition, the negative bias 12 lower than the threshold voltage is applied to the gate of the gate control diode of the own arm at a timing 35 at which an "on" command is input to the own-arm IGBT. Subsequently, in a diode conduction duration 28, carrier extraction is started by applying the zero bias or positive bias 11 to the gate.

Thereafter, the carrier extraction duration t_{d_rr} is set to a fixed duration "b", and an "off" command is input to the gate of the own-arm IGBT. In addition, after DT34, an "on" command is input to the gate of the paired-arm IGBT, and the paired-arm IGBT reaches the turn-on 18. In other words, the gate control diode reaches the reverse recovery state. Then, after the gate control diode reaches the non-conduction state through the reverse recovery duration tᵣᵣ 37, the negative bias 12 lower than the threshold voltage is applied to the gate again to prepare the next forward recovery state in a sequence.

A condition that the duration t_{off} 19 is shorter than the duration "b" + t_{fr} will be described below. Under the condition, the zero bias or positive bias 11 is applied to the gate of the gate control diode at the timing 35 at which an "on" command is input to the own-arm IGBT in a state in which the negative bias 12 lower than the threshold voltage is applied to the gate of the gate control diode.

Thereafter, the carrier extraction duration t_{d_rr} is controlled to maintain the sum f + DT of an "on" command duration f of the own-arm IGBT and the dead time. For this, the carrier extraction duration t_{d_rr} is controlled with a variable value synchronized with the "on" command duration f of the own-arm IGBT, in other words, the non-conduction duration t_{off} 19 of the paired-arm IGBT. Thereafter, an "off" command is input to the gate of the own-arm IGBT. In addition, after DT34, an "on" command is input to the gate of the paired-arm IGBT, and the paired-arm IGBT reaches the turn-on 18. In other words, the gate control diode reaches the reverse recovery state.

Then, after the gate control diode reaches the non-conduction state 27 through the reverse recovery duration tᵣᵣ 37, the negative bias 12 lower than the threshold voltage is applied to the gate again to prepare the next forward recovery state. Through application of the above-described control, even when the diode conduction duration is changed due to the PWM operation of the inverter, the forward recovery loss, the conduction loss, and the reverse recovery loss can be minimized since the negative bias lower than the threshold voltage is provided to the gate at forward recovery and the zero bias or positive bias is provided to the gate at reverse recovery.

According to Example 2, the relation that an "on" command is complementarily input to the gate control signal of the paired-arm IGBT and the gate control signal of the own-arm IGBT with DT interposed therebetween can be exploited to generate the gate control signal of the gate control diode by using the gate control signal of the own-arm IGBT.

Note that, in the above-described control, the t_{d_rr} value of f + DT in variation corresponds to a case in which the reverse recovery duration tᵣᵣ of the diode is shorter than the dead time DT of the paired arms, and in a case in which tᵣᵣ is longer than DT, the same effect is obtained by delaying the timing of providing zero or positive bias to the gate control diode behind the timing of an "on" command to the own-arm IGBT by a constant time x, in other words, by setting t_{d_rr} to f + DT - x.

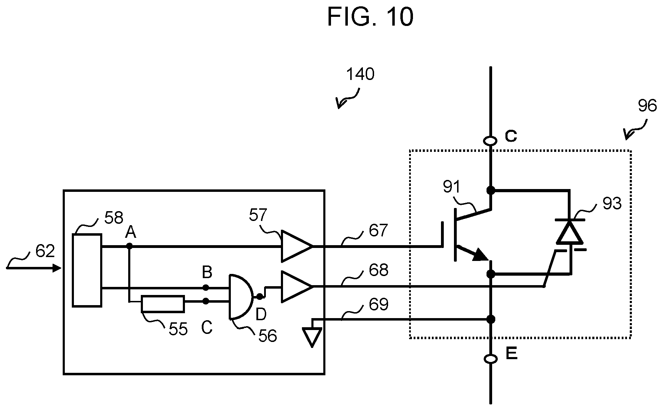

Figure 10 is a circuit diagram of an inverter 140 in which the gate control circuit 66 that achieves the control method in Figures 9A and 9B is coupled to an arm 96. As illustrated in Figure 10, in the inverter 140, the gate control circuit 66 is a circuit configured to receive a command signal 62 of the PWM operation of the inverter and generate a gate control signal of the IGBT 91 and the gate control diode 93. The gate control signal is a voltage signal that is input to the gate terminal 67 of the IGBT and the gate terminal 68 of the gate control diode with the reference potential at the emitter sense terminal (emitter electrode) 69 of the IGBT 91 and the gate control diode 93.

The gate control circuit 66 receives the command signal 62 of the PWM operation and generates an operation trigger signal A of the IGBT and a fixed pulse signal B of the gate control diode at a trigger-signal generation block 58. The operation trigger signal A of the IGBT is set at the generation block 58 in advance to have the same on-off duration as that of the command signal 62, and the fixed pulse signal B is set at the generation block 58 in advance to turn on a constant time before inputting of a turn-off command of the IGBT.

In addition, a signal C and a signal B obtained by delaying A by a constant time through a delay block 55 are input to a logical conjunction block 56 to generate a trigger signal D of the gate control diode. Accordingly, a signal with which t_{d_rr} is controlled to vary in accordance with the "on" command duration of the IGBT is generated. The operation trigger signal A of the IGBT and the operation trigger signal D of the gate control diode are converted into signals having voltage adjusted by an output buffer 57 and control the gate terminals 67 and 68 of the IGBT 91 and the gate control diode 93.

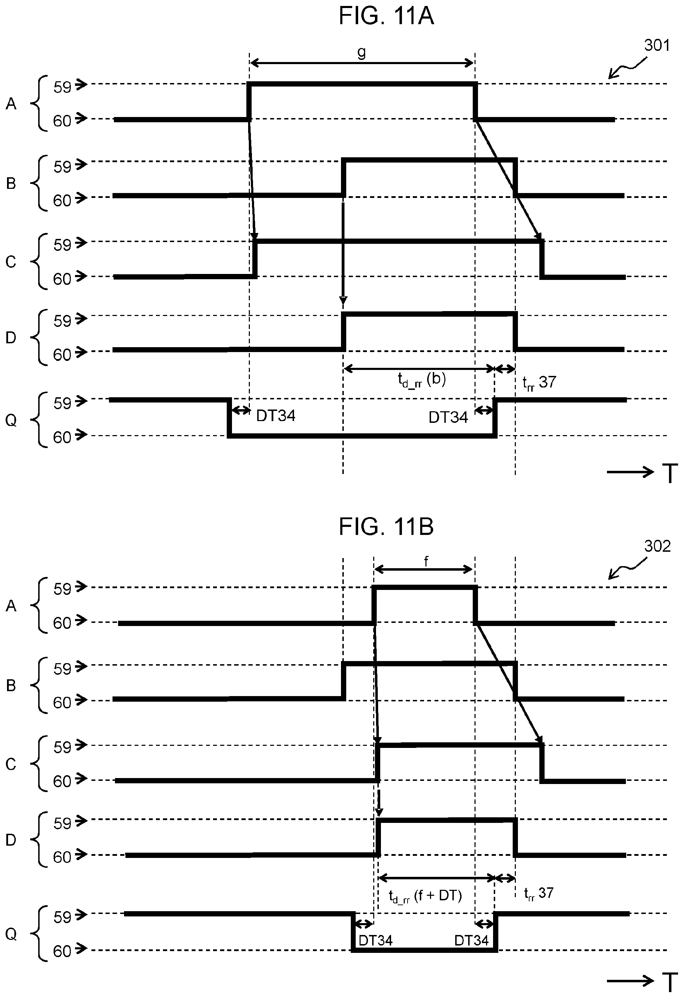

Figure 11A is a timing chart 301 illustrating a sequence of each signal in the gate control circuit 66 in Figure 10 and illustrating a case in which the "on" command duration is long. Figure 11B is a timing chart 302 illustrating a case in which the "on" command duration is shorter than in Figure 11A. Figures 11A and 11B illustrate sequences of signals A and B in a case in which a command signal of a pulse g for which the "on" command duration of the IGBT is long is input and in a case in which a command signal of a pulse f for which the "on" command duration of the IGBT is short is input. The long pulse corresponds to a case in which t_{d_rr} of the gate control diode can be controlled with a fixed value, and the short pulse corresponds to a case in which t_{d_rr} is controlled with a variable value.

Note that, in Figures 11A and 11B, the vertical axis represents an "on" level 59 and an "off" level 60, and the horizontal axis represents time T. When the command signal of the long pulse g is input, the trigger signal D of the gate control diode rises upon rising of the fixed pulse signal B generated at the generation block 58 in the gate control circuit 66, and the duration of the fixed value b is provided as the carrier extraction duration t_{d_rr} before the gate control diode performs reverse recovery after the paired-arm IGBT is turned on by the signal A at the gate control circuit in paired-arm disposition.

On the other hand, when the command signal of the short pulse f is input, the trigger signal D of the gate control diode rises upon rising of the signal C obtained by delaying the signal A by a constant time, and the carrier extraction duration t_{d_rr} before the gate control diode performs reverse recovery after the paired-arm IGBT is turned on by the signal A at the gate control circuit in paired-arm disposition is a variable value in accordance with the "on" command duration f of the signal A.

In any case of the long "on" command duration g and the short "on" command duration f, the gate of the trigger signal D of the gate control diode can wait at an "off" level in a duration in which the gate control diode performs forward recovery after the paired-arm IGBT is turned off, and thus the negative bias lower than the threshold voltage can be provided to the gate of the gate control diode.

In a duration in which the gate control diode performs reverse recovery after the paired-arm IGBT is turned on, the gate of the trigger signal D of the gate control diode can wait at an "on" level, and thus the zero bias or positive bias can be provided to the gate of the gate control diode under a condition that t_{d_rr} is variable. Note that Q in Figures 11A and 11B illustrates the signal A (refer to Figure 10) of the paired-arm gate control circuit, which is omitted in Figure 10.

When the fall timing of the variable pulse signal C due to the fixed pulse signal B or the signal A is set to be after the reverse recovery duration tᵣᵣ 37 of the gate control diode based on consideration of tᵣᵣ 37, the negative bias lower than the threshold voltage can be applied to the gate again after reverse recovery of the gate control diode, thereby preparing the next forward recovery state. Thus, a gate control sequence that minimizes the forward recovery loss, the conduction loss, and the reverse recovery loss at the gate control diode can be provided to a command signal having any "on" command width by the example.

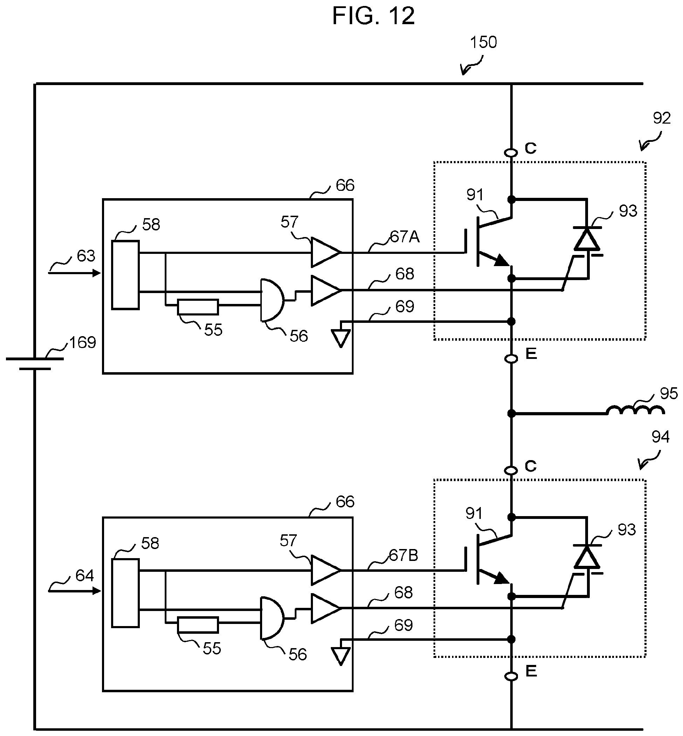

Figures 12 to 14 illustrate a circuit diagram and operation waveforms of an inverter to which the control method of Example 1 is applied. Figure 12 is a circuit diagram of an inverter 150 to which the control method in Figures 9A and 9B is applied. In a circuit of the inverter 150 illustrated in Figure 12, the gate control circuit 66 that can derive the above-described operation sequence, and the IGBT 91 coupled thereto and the gate control diode 93 are disposed in each of the paired arms 92 and 94, the inductive load 95 is installed at the neutral point 90, and the paired arms are coupled to the direct-current power source 169.

In addition, in the circuit of the inverter illustrated in Figure 12, a signal 63 and a signal 64 that command complementary operation with which the inverter performs PWM operation and outputs alternating-current power are input to the gate control circuits 66 in the paired arms. Trigger signals of the IGBTs 91 and the gate control diodes 93 are generated inside the gate control circuits 66 having received the signal 63 and the signal 64. The trigger signals are coupled to the gate terminals 67 of the IGBTs 91 and the gate terminals 68 of the gate control diodes 93.

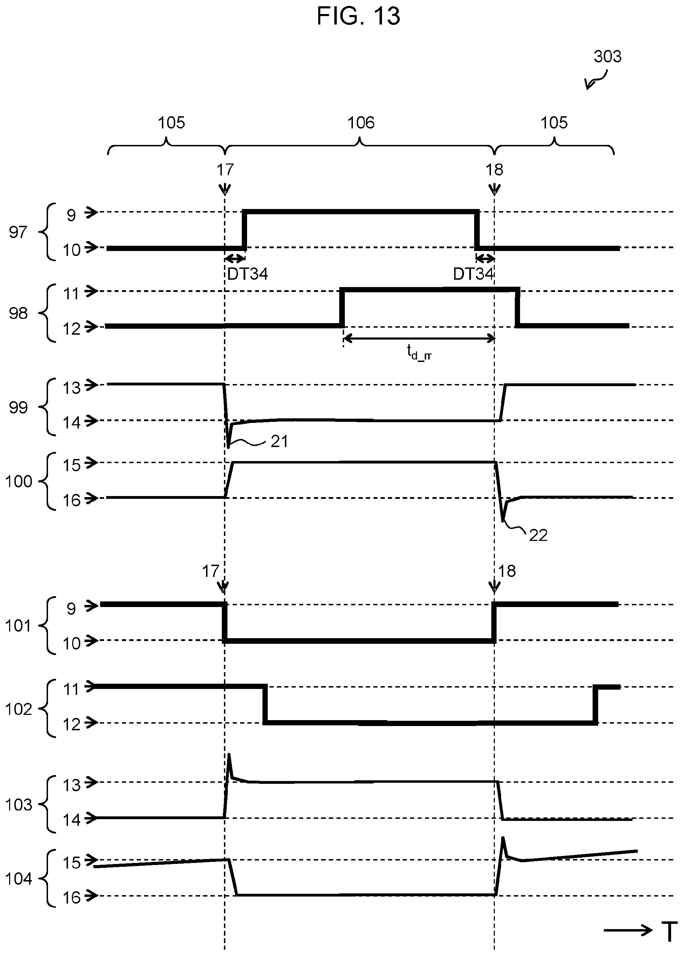

Figure 13 is a timing chart 303 illustrating gate waveforms and main circuit waveforms of the IGBTs and the gate control diodes in the paired arms at regeneration operation of the inverter in Figure 12. Figure 13 illustrates gate waveforms 97, 98, 101, and 102 and main circuit waveforms 99, 100, 103, and 104 of the paired arms in a state in which current flows from the inductive load 95 toward the neutral point 90 of the paired-arm IGBTs, in other words, regeneration operation in which current is sucked from the load to the inverter.

Note that Figure 13 illustrates the gate control signal 97 of the upper-arm IGBT, the gate control signal 98 of the upper-arm gate control diode, a cathode-anode voltage V_{KA} 99 of the upper-arm gate control diode, a cathode current I_{K} 100 of the upper-arm gate control diode, the gate control signal 101 of the lower-arm IGBT, the gate control signal 102 of the lower-arm gate control diode, a collector-emitter voltage V_{CE} 103 of the lower-arm IGBT, and collector current I_{C} 104 of the lower-arm IGBT.

Main circuit waveforms are waveforms of voltage V_{CE} or V_{KA} applied between collector and emitter terminals or between cathode and emitter terminals of an IGBT or a diode coupled in antiparallel and current I_{C} flowing through the IGBT or the current I_{K} flowing through the diode. Note that Figure 13 illustrates state transition from a conduction duration 105 of the IGBT in the lower arm to the conduction duration 105 of the IGBT in the lower arm again through a diode conduction duration 106 of the upper arm. First, a turn-off command 17 is input to the gate of the lower-arm IGBT while the IGBT in the lower arm is conducting, and accordingly, current is commutated to the gate control diode of the upper arm, thereby reaching the forward recovery state.

The negative bias 12 lower than the threshold voltage is applied to a gate 98 of the gate control diode of the upper arm by the gate control circuit in the upper arm, and the forward recovery loss is small. Subsequently, after the diode conduction duration 106 of the upper arm, when a turn-on command 18 is input to the gate of the lower-arm IGBT, current is commutated to the IGBT in the lower arm and the gate control diode of the upper arm becomes the reverse recovery state. In the diode conduction duration 106 of the upper arm, the zero bias or positive bias 11 of the t_{d_rr} duration controlled as a variable value is input, and thus the reverse recovery loss is small.

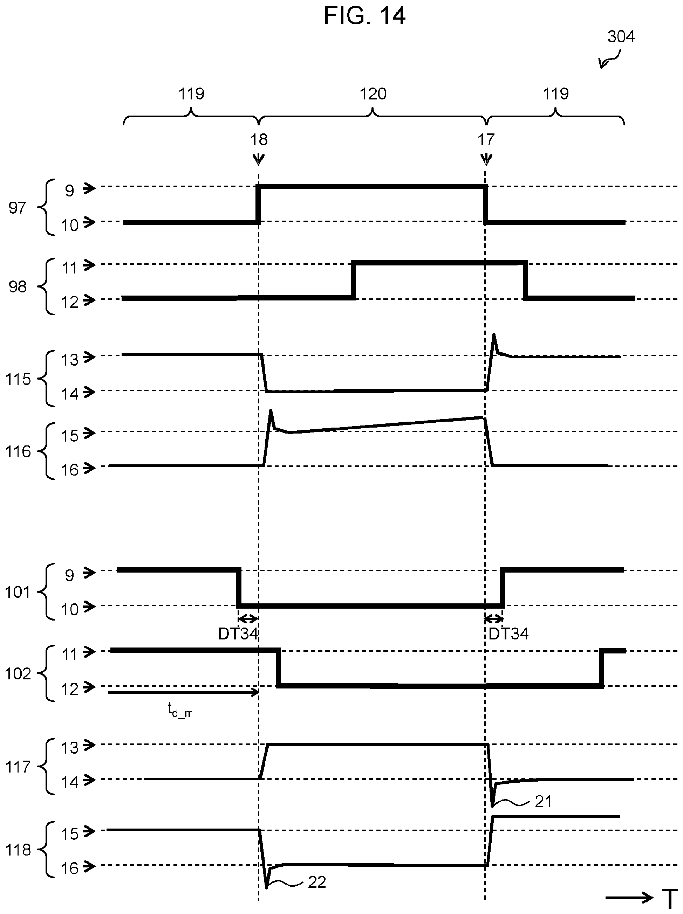

Subsequently, gate waveforms 97, 98, 101, and 102 and main circuit waveforms 115, 116, 117, and 118 of the paired arms in a state in which current flows from the neutral point 90 of the paired-arm IGBT toward the inductive load 95, in other words, powering operation in which current is fed from the inverter to the load will be described with reference to Figure 14. Figure 14 is a timing chart 304 illustrating gate waveforms and main circuit waveforms of the IGBTs and the gate control diodes in the paired arms at powering operation of the inverter in Figure 12. Note that Figure 14 illustrates collector-emitter voltage V_{CE} 115 of the upper-arm IGBT, collector current I_{C} 116 of the upper-arm IGBT, cathode-anode voltage V_{KA} 117 of the lower-arm gate control diode, and cathode current I_{K} 118 of the lower-arm gate control diode.

State transition from a diode conduction duration 119 of the lower arm to the diode conduction duration 119 of the lower arm again through an IGBT conduction duration 120 of the upper arm is illustrated. First, when the turn-on command 18 is input to the gate of the upper-arm IGBT in a state 119 in which the diode in the lower arm is conducting, current is commutated to the IGBT in the upper arm and the diode in the lower arm becomes the reverse recovery state. In the diode conduction duration 119 of the lower arm, the zero bias or positive bias 11 of the t_{d_rr} duration controlled as a variable value is input, and thus the reverse recovery loss is small.

Subsequently, after the IGBT conduction duration 120 of the upper arm, when the turn-off command 17 is input to the gate of the upper-arm IGBT, current is commutated to the diode in the lower arm and the diode in the lower arm becomes the forward recovery state. The negative bias 12 lower than the threshold voltage is applied to the gate of the gate control diode in the lower arm by the gate control circuit in the lower arm, and the forward recovery loss is small.

In other words, when gate control circuits to which the control method of the example is applied are disposed in paired arms, an electric power loss that occurs in the forward recovery state, the conduction state, and the reverse recovery state of the diodes in the paired arms can be controlled to minimum in any of powering operation and regeneration operation of the inverter, and accordingly, size reduction and high efficiency of the inverter are achieved.

Note that the method of Example 2 is the method illustrated in the timing charts 300 to 304 in Figures 9A, 9B, 11A, 11B, 13, and 14. As described above, each gate control diode (semiconductor circuit) 93 can minimize losses such as the forward recovery loss, the conduction loss, and the reverse recovery loss in the PWM operation of the inverter to which the method according to Example 2 of the present invention is applied.

### [Example 3]

A gate-control-diode control method according to Example 3 of the present invention will be described below with reference to Figures 15 to 17. Figure 15 is a circuit diagram illustrating an inverter 160 in which a gate control circuit 66 that achieves the method of Example 3 is coupled to an arm 96. As illustrated in Figure 15, the inverter 160 includes the gate control circuit 66, and an IGBT 91 coupled thereto and a gate control diode 93. The gate control circuit 66 is a circuit configured to receive the command signal 62 of the PWM operation of the inverter and generate a gate control signal of the IGBT 91 and the gate control diode 93.

The gate control signal is a voltage signal that is input to the gate terminal 67 of the IGBT and the gate terminal 68 of the gate control diode with the reference potential at the emitter sense terminal 69 of the IGBT 91 and the gate control diode 93. The gate control circuit 66 receives the command signal 62 of the PWM operation and generates an operation trigger signal E of the IGBT and a fixed pulse signal F of the gate control diode at the trigger-signal generation block 58.

The trigger-signal generation block 58 includes a delay circuit 53 configured to delay on-off timings by a constant duration while maintaining the same "on" command duration as that of the command signal 62, and a circuit 54 configured to generate a fixed pulse of a constant duration upon the "off" command of the command signal 62. A signal G and a signal F obtained by further delaying the operation trigger signal E of the IGBT by a constant time are input to the logical conjunction block 56 to generate a trigger signal H of the gate control diode.

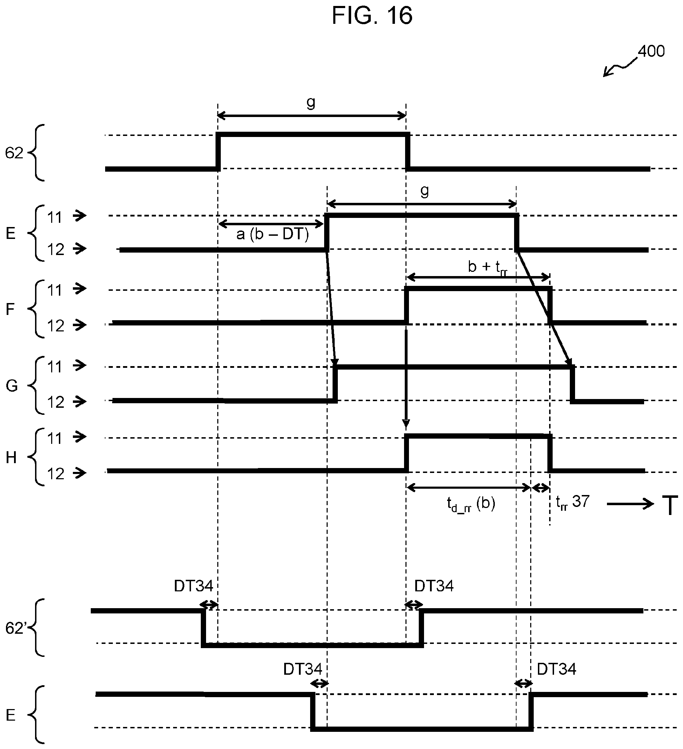

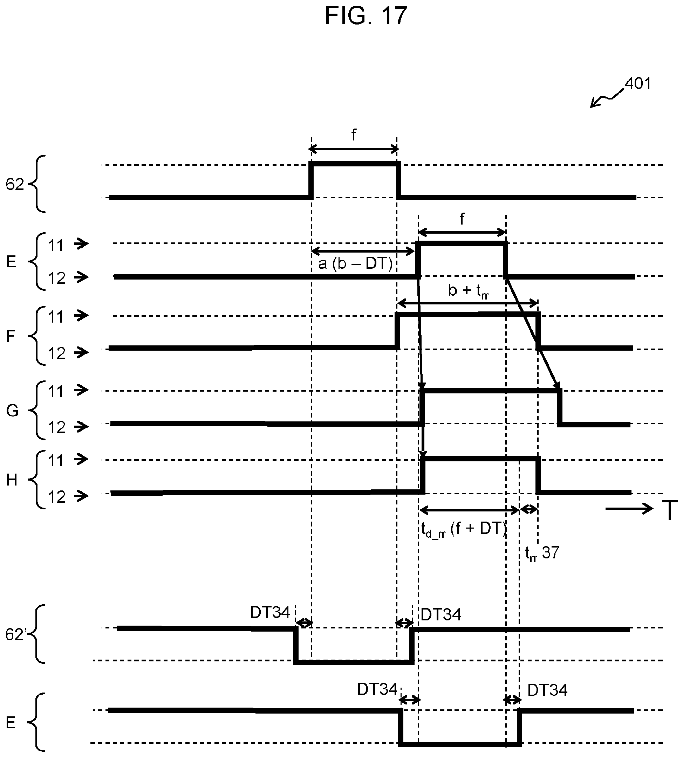

Accordingly, a signal with which t_{d_rr} is controlled to vary in accordance with the "on" command duration of the IGBT is generated. The operation trigger signal E of the IGBT and the operation trigger signal H of the gate control diode are converted into signals having voltage adjusted by the output buffer 57 and control the gate terminals 67 and 68 of the IGBT 91 and the gate control diode 93. Note that, when there is a non-illustrated arm that is paired with the arm 96 in Figure 15 as an upper arm, a command signal 62' and the operation trigger signal E for the IGBT 91 of the paired arm are as illustrated at lower parts in Figures 16 and 17.

Figure 16 is a timing chart 400 illustrating a sequence of each signal in the gate control circuit in Figure 15 when the command pulse width is long, in particular. Figure 16 illustrates sequences of signals E to H when a pulse g for which the "on" command duration of the IGBT is long is input, a command signal of the paired arm for which a dead time DT34 is provided and to which an "on" command is complementarily input, and a sequence of the signal E. The long pulse corresponds to a case in which t_{d_rr} can be controlled with a fixed value. When the command signal 62 is input, the signal E having the same pulse width g and delayed by a constant duration "a" is generated.

The constant duration "a" is a value b - DT that is obtained by subtracting the dead time DT34, which is the "on" command interval of the paired arms, from the fixed t_{d_rr} duration b that is effective for reduction of the reverse recovery loss at the gate control diode. Subsequently, the signal F rises upon falling of the command signal 62 and is turned on for a constant duration.

The constant duration is the sum b + tᵣᵣ of b and the reverse recovery duration tᵣᵣ 37. The signal G is generated from the signal E through delaying based on the forward recovery time and the reverse recovery time of the gate control diode. The signal H is generated through logical conjunction of the signal F and the signal G, and in this case, the signal H rises upon rise of the fixed pulse signal F and is provided with the duration of the fixed value b as the carrier extraction duration t_{d_rr} before the gate control diode performs reverse recovery after the paired-arm IGBT is turned on by the signal E of the paired arm.

Figure 17 is a timing chart 401 illustrating a sequence of each signal in the gate control circuit 66 in Figure 15 when the command pulse width is short, in particular. Specifically, Figure 17 illustrates a case in which the command signal 62 of the pulse f for which the conduction time is short is input to the gate control circuit 66. Note that the method of Example 3 is the method illustrated in the timing charts 400 and 401 in Figures 16 and 17.

When the pulse is shorter than b - DT, a sequence is such that the signal G delayed from the command signal 62 by a constant duration and having a variable width in accordance with the "on" command width of the command signal 62 is turned on with delay behind the signal F that has a fixed width and is turned on at falling of the command signal 62, and thus the signal H rises upon rising of the signal G and is provided with the duration of a variable value f + DT as the carrier extraction duration t_{d_rr} before the gate control diode performs reverse recovery after the paired-arm IGBT is turned on by the signal E of the paired arm.

In this manner, the generation block 58 in the gate control circuit 66 of Example 3 has a circuit configuration including the delay circuit 53 configured to delay on-off timings by a constant duration while maintaining the same "on" command duration as that of the command signal 62, and the circuit 54 configured to generate a fixed pulse of a constant duration upon the "off" command of the command signal 62. Such a gate control circuit 66 can generate a signal that can constantly minimize a loss at the diode 93 by controlling t_{d_rr} to vary in accordance with command widths having various conduction widths.

As described above, losses at the diode 93, such as the forward recovery loss, the conduction loss, and the reverse recovery loss can be minimized in the PWM operation of an inverter 160 to which the method of Example 3 is applied.

### [Example 4]

A three-phase alternating-current inverter as an electric power converter to which a gate-control-diode control method according to Example 4 of the present invention is applied will be described below with reference to Figures 18 and 19. Figure 18 is a circuit diagram of a three-phase alternating-current inverter 500 to which the method of Example 4 is applied, illustrating a circuit in which a total of six sets of a control circuit 66, an IGBT 91 coupled thereto, and a gate control diode 93 are disposed in a three-phase paired-arm configuration.

A motor 950 as an inductive load is disposed at neutral points 121, 122, and 123 of paired arms, and the paired arms are coupled to a direct-current power source 169. A signal that commands complementary operation of each phase with which the inverter 501 performs PWM operation and outputs alternating-current power and the motor performs rotation is input from a command unit 951 to each gate control circuit 66 of the corresponding paired arm.

Upon reception of the command signal, trigger signals of the IGBT and the gate control diode are generated inside the gate control circuit 66 disposed in each arm of each phase and are coupled to the gate terminals of the IGBT 91 and the gate control diode 93. The gate control diode operates with the signal generated at the gate control circuit 66 in accordance with the control method described in Example 4, thereby minimizing electric power losses that occur in the forward recovery state, the conduction state, and the reverse recovery state.

Figure 19 is a circuit diagram of a three-phase alternating-current inverter 501 to which a gate-control-diode control method according to a modification of Figure 18 and a dual-gate IGBT are applied. As illustrated in Figure 19, a dual-gate IGBT 901 includes two insulated gate terminals and can reduce switching and conduction losses at the IGBT by performing control with two signals provided with a timing delay duration by which carrier concentration can be controlled at conduction and switching.

A gate control circuit 902 in each arm of each phase generates, for a common emitter sense in accordance with a command signal, a total of three gate signals for the two gates of the dual-gate IGBT 901 in addition to the gate of a gate control diode 93. Accordingly, a loss reduction effect at the IGBT 901 can be obtained in addition to the loss reduction effect at the gate control diode 93, and as a result, efficiency improvement and size reduction of the three-phase alternating-current inverter 501 can be achieved.

As described above, according to the method of the modification, losses at the diode 93, such as the forward recovery loss, the conduction loss, and the reverse recovery loss can be minimized to achieve the highly efficient inverter (electric power converter) 501.

### [Basic technologies]

Basic technologies of the present invention will be described below with reference to Figure 20. Figure 20 is a circuit diagram of a three-phase inverter 600 having an arm-pair configuration as the basic technologies of the present invention. As illustrated in Figure 20, in the three-phase inverter 600, an IGBT 170 including an insulation gate terminal (abbreviated as "gate") 171 is coupled to a diode 172 in antiparallel to the IGBT 170.

The inverter 600 has a configuration in which electric power is supplied from a voltage source 169 and electric power supplied to a coupled inductive load 168 is controlled as the IGBT 170 repeatedly turns on and off at high speed with voltage applied to a gate 171. Note that the inductive load 168 is, for example, a motor (electric motor).

The IGBT 170 and the diode 172 generate a conduction loss at conduction and a switching loss at switching, and the temperature thereof increases due to heat resistance of an element and its surroundings. Accordingly, the density of current that can flow through the IGBT and the diode is determined by a highest allowable temperature, and thus a predetermined volume by parallel coupling is needed to satisfy desired rated current of the inverter.

Reduction of losses at the IGBT and the diode together with reduction of heat resistance is effective for size reduction and high efficiency of the inverter. The losses are roughly classified into a conduction loss generated when the IGBT and the diode conduct and a switching loss generated at the IGBT and the diode when the IGBT switches.

The switching loss is divided into four losses of a turn-on loss generated when the IGBT turns on, a reverse recovery loss at the diode in a paired arm, a turn-off loss generated when the IGBT turns off, and a forward recovery loss at the diode in the paired arm.

Element temperature increase can be suppressed by reducing these losses, and thus allowable current density can be increased, in other words, the number of parallel couplings and the element area can be reduced to achieve size reduction and high efficiency of the inverter.

### [Comparative example]

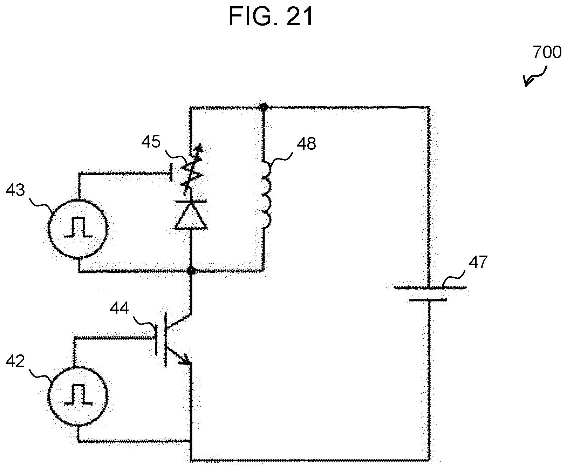

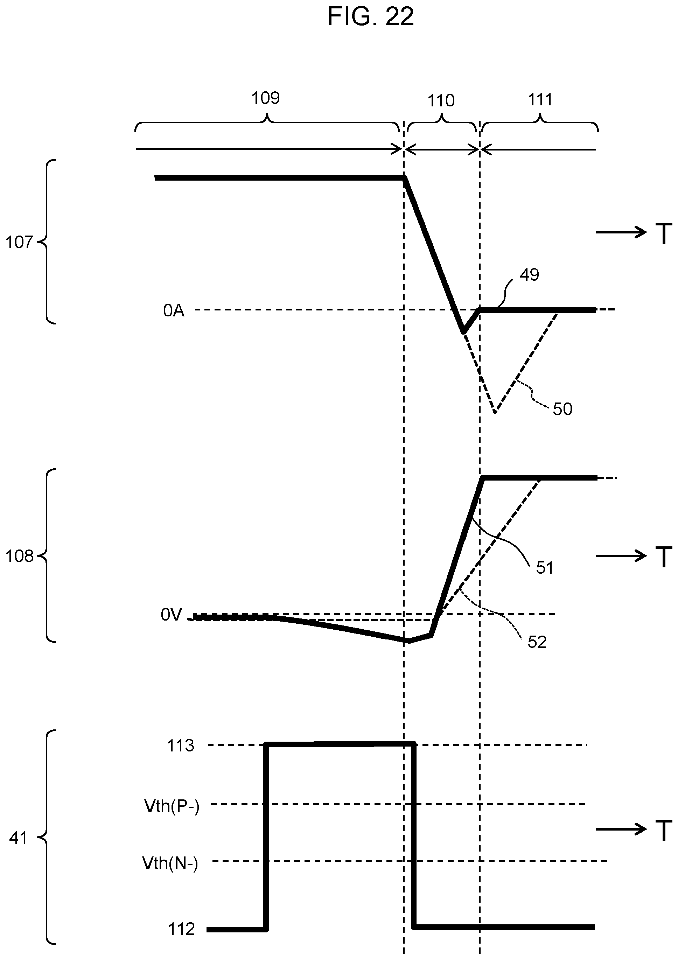

A gate control diode as a comparative example of the present invention will be described in detail below with reference to Figures 21 and 22. The gate control diode is a technology that reduces a reverse recovery loss at the diode, and includes a structure in which a gate electrode capable of controlling the concentration of carriers injected into a drift area is disposed on the surface of an anode area, and its control technology.

Figure 21 is a diagram of an evaluation circuit 700 that evaluates recovery characteristics of the diode assumed for operation of an electric power conversion apparatus configured to generate alternating-current output from a direct-current power source. As illustrated in Figure 21, the evaluation circuit 700 has a circuit configuration in which a gate control diode 45 and an IGBT 44 in a paired arm are coupled in series to a direct-current power source 47 and an inductive load 48 is coupled in parallel to the diode 45. In the evaluation circuit 700, alternating-current output voltage is generated at both ends of the inductive load 48 in accordance with an input signal 42 to the gate of the IGBT 44.

Figure 22 is a timing chart illustrating recovery characteristics obtained by the evaluation circuit 700 in Figure 21. Figure 22 is a timing chart illustrating the recovery characteristics by the evaluation circuit 700 in Figure 21. A gate control signal 43 in Figure 21, a current waveform 107 as a switching characteristic obtained in accordance with the gate control signal 43, and a cathode-anode voltage waveform 108 as the same characteristic are illustrated as the recovery characteristics.

The gate control diode 45 can reduce the conduction loss in a conduction duration 109 as the concentration of carriers injected into the drift area increases with a negative bias 112 lower than a threshold voltage applied to the gate and the forward-direction voltage decreases. Subsequently, current 107 at the diode 45 attenuates as the IGBT in the paired arm turns on. In addition, reverse recovery current 49 in the opposite direction transiently occurs as remaining carriers return, followed by a reverse recovery duration 110 in which cathode-anode voltage 108 increases.

Reverse recovery current 50 at the pn diode, which has been conventionally large as illustrated with a dashed line in Figure 22, decreases like the reverse recovery current 49 illustrated with a solid line. This is followed by a non-conduction duration 09 in which cathode-anode voltage 51 reaches power voltage and becomes stabilized. Cathode-anode voltage 52 at the pn diode, which has been conventionally large as illustrated with a dashed line in Figure 22, decreases like the cathode-anode voltage 51 illustrated with a solid line.

In the evaluation circuit 700 in Figure 21, the concentration of carriers injected from the anode is decreased by applying a positive bias 113 equal to or higher than the threshold voltage to the gate right before a reverse recovery duration 110 In addition, carriers in the drift area are discharged to the anode through an electron inversion layer generated at an oxide film interface, and accordingly, the carrier concentration of the drift area temporarily decreases. As a result, reverse recovery current decreases in the reverse recovery duration 110, and the reverse recovery loss is reduced as the speed of increase of the cathode-anode voltage 51 increases.

In other words, at the gate control diode 45 of the evaluation circuit 700 in Figure 21, the conduction loss and the reverse recovery loss can be reduced by its structure and gate control scheme. In addition, a loss also occurs at the diode 45 in the forward recovery state, and reduction of the loss is important as well. Commutation occurs to the diode when the IGBT in the paired arm turns off, and the forward recovery state is a state in which transitory anode-cathode voltage increase occurs at carrier filling in the drift area of the diode 45 in the commutation.

The forward recovery loss is generated by the product of current and voltage increase due to commutation. An adverse effect of forward recovery loss increase occurs when the IGBT in the paired arm turns off and overlapping with a state in which the diode performs forward recovery occurs in a duration in which control of applying a positive bias equal to or higher than the threshold voltage to the gate is provided right before the reverse recovery loss to reduce the reverse recovery loss.

This occurs because, when the positive bias equal to or higher than the threshold voltage is applied to the gate, the concentration of carriers injected from the anode decreases, and accordingly, cathode-anode voltage needed for filling with a certain amount of carriers necessary for commutation increases.

An inverter is an apparatus configured to convert direct current into alternating current through modulation (pulse width modulation (PWM)) of the pulse width of a paired arm as a conduction command for an IGBT, and needs to take control at various pulse widths into account in order to maintain the quality of alternating-current waveform. Thus, since a loss occurs to the gate control diode 45 of the evaluation circuit 700 in Figure 21 in the forward recovery state as well, the present invention is intended to reduce the loss.

The semiconductor-circuit control methods according to Examples 1 to 4 of the present invention and the electric power converters to which the semiconductor-circuit control methods are applied can be summarized as follows.
[1] A semiconductor circuit to be controlled by this method is a semiconductor circuit including paired arms 92 and 94 in each of which a gate control diode 93 or 203 is coupled to an IGBT 91 or 901 and that are coupled in series. More specifically, the method is preferable for the single-phase PWM inverters 130 and 150 illustrated in Figure 2 (Example 1) and Figure 12 (Example 2) and the three-phase inverters 500 and 501 illustrated in Figure 18 (Example 4) and Figure 19 (the modification of Example 4).

In the semiconductor circuit, the arms 92 and 94 have a circuit configuration in which a conduction direction through the collector and the emitter of each BT 91 or 901 and a conduction direction through the anode 86 and the cathode 89 of the gate control diode 93 or 203 are coupled in antiparallel, in other words, coupled in parallel in opposite directions. The paired arms have a circuit configuration in which the gate control diode 93 or 203 and the IGBT 91 or 901 in the one arm 92 (94) are coupled in series to the gate control diode 93 or 203 and the IGBT 91 or 901, respectively, in the other arm 94 (92).

In the gate control diode 93 or 203, the anode electrode 86, the cathode electrode 89, and the gate electrode 81 are provided on a semiconductor substrate and insulated from one another. The gate control diode 93 or 203 has characteristics as follows, in particular. The carrier concentration of the drift area 87 in the semiconductor substrate is controlled in accordance with voltage applied to the gate electrode 81. As the carrier concentration is controlled, the gate control diode 93 or 203 operates as follows.

In the reverse recovery state, a voltage signal of zero bias or positive bias 70 with which an electron layer is generated at the interface of the gate electrode 81 is applied between the gate electrode 81 and the anode electrode 86. In the forward recovery state, a voltage signal of negative bias with which a hole layer is generated at the interface of the gate electrode 81 is applied between the gate electrode 81 and the anode electrode 86. After the forward recovery state, the negative bias 71 is switched to a voltage signal for applying the zero bias or positive bias 70.

This method performs control so that the pulse width of the other arm 94 (92) is determined in accordance with the pulse width of the one paired arm 92 (94). More specifically, the gate control diode 93 or 203 controls the duration of application of the zero bias or positive bias 70 to vary in accordance with the non-conduction duration of the IGBTs 91 or 901 coupled in series. With such a semiconductor-circuit control method, it is possible to achieve electric power consumption reduction and size reduction by improving a transient response characteristic, in other words, an ON/OFF transition state for various pulse conditions in the PWM operation of an inverter and reducing the forward recovery loss as well as the conduction loss that occurs at the diode.

[2] The methods according to Examples 1 to 4 of the present invention perform control based on the following definition as illustrated in Figures 1A and 1B in addition to the method described above in [1]. First, the non-conduction duration of the IGBTs 91 or 901 coupled in series is denoted by t_{off}. In addition, the state of the gate control diode 93 or 203 is defined as follows. The duration in which the reverse recovery state is reached after the zero bias or positive bias 70 is applied between the gate electrode 81 and the anode electrode 86 is denoted by t_{d_rr}. The duration of the forward recovery state is denoted by t_{fr}.

Control is performed so that the non-conduction duration t_{off} and the duration t_{d_rr} + t_{fr} as the sum of the duration t_{d_rr} in which the reverse recovery state is reached and the duration t_{fr} of the forward recovery state satisfy t_{off} ≥ t_{d_rr} + t_{fr}. In addition, the duration t_{d_rr} in which the reverse recovery state is reached is controlled to vary in accordance with the length of the non-conduction duration t_{off}. Accordingly, the above-described transient response characteristic becomes more excellent so that ON/OFF switching can be completed with a smaller heat generation loss.

[3] The methods according to Examples 1 to 4 of the present invention perform control based on the following definition in addition to the method described above in [2]. First, a fixed duration that does not depend on the non-conduction duration t_{off} is denoted by b. As illustrated in Figure 9A, the fixed duration "b" is the duration t_{d_rr} in which the recovery state is reached when the non-conduction duration t_{off} satisfies a relation t_{off} > b + t_{fr}. The duration t_{d_rr} in which the recovery state is reached is controlled to vary in accordance with the non-conduction duration t_{off}. Accordingly, the above-described transient response characteristic becomes more excellent so that ON/OFF switching can be completed with a smaller heat generation loss.

[4] Semiconductor circuits such as the single-phase PWM inverters 130 and 150 and the three-phase inverters 500 and 501 are to be controlled by the methods according to Examples 1 to 4 of the present invention in addition to the method described above in [3]. Each semiconductor circuit has a circuit configuration including the first IGBT 91 or 901 disposed in the one paired arm 92, the second IGBT 91 or 901 disposed in the other paired arm 94, and the gate control diode 93 or 203 coupled in series to the first IGBT 91 or 901. The first gate terminal 67A is a terminal capable of applying voltage between the gate electrode and the emitter sense terminal (emitter electrode) 69 of the first IGBT 91 or 901. The second gate terminal 67B is a terminal capable of applying voltage between the gate electrode 67A and the emitter electrode 69 of the second IGBT 91 or 901.

A voltage signal (Figures 2, 12, 18, and 19) with which the first IGBT 91 or 901 and the second IGBT 91 or 901 are controlled to complementarily conduction or not conduct at a constant interval and that is based on the first PWM command signal 63 and the second PWM command signal 64 having modulated pulse widths is input to the first gate terminal and the second gate terminal. A voltage signal applied between the gate electrode 81 and the anode electrode 86 of the gate control diode 203 as exemplarily illustrated in Figures 7A, 7B, and 8 is generated based on the second PWM command signal 64. Accordingly, the above-described transient response characteristic becomes more excellent.

[5] In the methods according to Examples 1 to 4 of the present invention in addition to the method described above in [4], the voltage signal applied between the gate electrode 81 and the anode electrode 86 of the gate control diode 93 or 203 is generated at the same gate control circuit board 66 or 902 (Figures 2, 12, 18, and 19) upon reception of a voltage signal applied to the second gate terminal 67B and the second PWM command signal 64. In this manner, the present invention can be easily performed.

[6] In the method according to Example 2 of the present invention in addition to the method described above in [5], the timing of switching the voltage signal applied between the gate electrode 81 and the anode electrode 86 of the gate control diode 93 or 203 is generated by delaying the second PWM command signal 64 by a constant duration at the gate control circuit board 66 illustrated in Figure 12 and calculating the logical conjunction of a PWM trigger signal synchronized with the pulse width of the second PWM command signal 64 and a fixed trigger signal having a conduction command duration longer than the fixed duration "b". Accordingly, the present invention can be reliably performed.

[7] In the method according to Example 3 of the present invention in addition to the method described above in [6], the signal G illustrated in Figures 15 and 16 is generated from the signal E through delaying based on the forward recovery time and the reverse recovery time of the gate control diode. In other words, the falling timings of pulses of the PWM trigger signal and the fixed trigger signal are delayed until the reverse the recovery state of the gate control diode 93 or 203 elapses. Accordingly, the present invention can be more reliably performed.

[8] In the method according to Example 2 of the present invention in addition to the method described above in [7], as illustrated in Figures 11A and 11B, voltage signals delayed from the first PWM command signal 63 and the second PWM command signal 64 by the same constant duration "a" are input to the first gate terminal 67A and the second gate terminal 67B, respectively. When DT34 represents the interval duration between conduction command signals between the first PWM command signal 63 and the second PWM command signal 64, the first and second gate terminals 67A, 67B are controlled as defined below. First, the interval duration DT between the fixed duration "b" and constant duration "a" have a relation b = a + DT. In further control, at the falling timings of pulses of the second PWM command signal 64, an "on" command is input for the fixed trigger signal having a conduction command duration longer than the fixed duration "b".

[9] The electric power converters according to Examples 1 to 4 of the present invention are electric power converters to which any of the methods described above in [1] to [8] is applied, for example, the inverters 130, 150, 500, and 501 illustrated in Figures 2, 12, 18, and 19. In the following description, a first conduction type is the N type and a second conduction type is the P type, but the conduction types may be interchanged. In the inverter 130, 150, 500, or 501, the gate control diode 93 or 203 has characteristics as illustrated in Figures 7A and 7B. Specifically, the gate control diode 93 or 203 includes a semiconductor substrate of the first conduction type (N-type), a cathode area (the N+ cathode layer 88 and the cathode electrode 89) of the first conduction type, an anode area (the P-type anode layer 84 and the anode electrode 86) of the second conduction type (P-type), and the gate electrode 81.

The cathode area (the N+ cathode layer 88 and the cathode electrode 89) of the first conduction type (N-type) is provided on a first surface side of the semiconductor substrate. The anode area (the P-type anode layer 84 and the anode electrode 86) of the second conduction type (P-type) is provided on a second surface side opposite to the first surface side of the semiconductor substrate. The anode electrode 86 is disposed on the second surface side of the anode area (the P-type anode layer 84 and the anode electrode 86). The gate electrode 81 is adjacent to the anode area 86 through the gate insulating film 82.

In the gate electrode 81, the inside of a trench extending from the second surface side to the cathode area (the N+ cathode layer 88) through the anode area 86 (the P-type anode layer 84 and the anode electrode 86) is surrounded by the gate insulating film 82. The anode area 86 (77 and 84) contacts a well area (the N-type well layer 85) that is of the first conduction type and contacts the gate insulating film 82. The well area 85 is adjacent to the drift area (the N-type cathode drift layer 87) that is of the first conduction type and contacts the cathode area (the N+ cathode layer 88).

A hole layer is formed at part of the well area (the N-type well layer 85), the part contacting the gate insulating film 82, when the negative bias is applied to the gate electrode 81 with respect to the anode electrode 86. In the forward the recovery state, holes are injected from the hole layer formed in the well area (the N-type well layer 85) into the drift area (the N-type cathode drift layer 87). Accordingly, it is possible to provide the inverter 500 or 501 that can reduce the conduction loss and the forward recovery loss that occur at the diode under a pulse condition of PWM operation, thereby achieving energy saving and size reduction.

[10] In the electric power converter according to Example 4 of the present invention, the IGBT 901 described above in [9] is the dual-gate IGBT 901 including the first gate terminal and the second gate terminal as illustrated in Figure 19 and has a control function as follows. The dual-gate IGBT 901 transitions from the non-conduction state to the conduction state when a voltage equal to or higher than a threshold value is applied to at least one of the gate terminals. The dual-gate IGBT 901 transitions from the conduction state to the non-conduction state when voltages applied to the two gate terminals are both lower than the threshold value. Accordingly, it is possible to provide the inverter 130, 150, 500, or 501 that can reduce the conduction loss and the forward recovery loss that occur at the diode under a pulse condition of PWM operation, thereby achieving energy saving and size reduction.

[11] The electric power converters according to Examples 1, 2, and 4 of the present invention are each an electric power converter having a circuit configuration for converting direct current into single-phase or three-phase alternating current and supplying electric power to the load 950 in [9] or [10] described above, and are, for example, the single-phase inverters illustrated in Figures 2 and 12 and the three-phase inverters illustrated in Figures 18 and 19. Specifically, the electric power converter has a circuit configuration including the paired arms of pairs in a number in accordance with the number of phases of the alternating current obtained through the conversion. One end and the other end of each of the paired arms are input terminals coupled to positivity and negativity, respectively, for the direct current. A neutral point coupling the arms 92 and 94 of each of the pairs in a number in accordance with the number of phases is one of the alternating-current terminals 121 to 123 coupled to the load 950. Accordingly, it is possible to provide a highly practically usable single-phase or three-phase inverter that can achieve energy saving and size reduction.

### Reference Signs List

1 paired-arm IGBT gate control signal
2 gate-control-diode gate control signal
3 gate-control-diode cathode-anode voltage V_{KA}
4 gate-control-diode current I_{K}
5 time integral of product of gate-control-diode V_{KA} and I_{K}, generated energy E_{fr}
6 control of the present invention
7 control of comparative example
8 forward-recovery-loss increase amount ΔE_{fr}
9 "on" voltage
10 "off" voltage
11 zero bias or positive bias
12 negative bias lower than threshold voltage
13 high voltage (power voltage)
14 0V potential
15 high current (load current)
16 0A potential
17 turn-off of paired-arm IGBT
18 turn-on of paired-arm IGBT
19 non-conduction duration t_{off} of paired-arm IGBT
20 gate-control-diode carrier extraction duration t_{d_rr}
21 forward recovery voltage
22 reverse recovery current
23 forward recovery state
24 reverse recovery state
25 forward recovery voltage and large negative V_{KA} generation in comparative example
26 zero (reference)
27 gate-control-diode non-conduction duration
28 gate-control-diode conduction duration
29 loss E_{cond} that occurs in conduction state
30 loss E_{rrsw} that occurs in reverse recovery state
32 forward-direction voltage at conduction
33 gate control signal of own-arm IGBT
34 dead time DT
35 timing of "on" command inputting to own-arm IGBT
36 forward recovery duration t_{fr}
37 reverse recovery duration tᵣᵣ
42 control signal
43 gate-control-diode gate control signal
44 IGBT
45 gate control diode
47 direct-current power source
48 inductive load
49 conventional gate-control-diode reverse recovery current
50 conventional pn-diode reverse recovery current
51 cathode-anode voltage disclosed in Patent Literature 1
52 conventional pn-diode cathode-anode voltage
53 command delay block
54 "off" command trigger fixed pulse generation block
55 delay block
56 logical conjunction block
57 output buffer
58 trigger signal generation block
59 "on" level
60 "off" level
62 command signal of inverter PWM operation
63 upper-arm command signal
64 lower-arm command signal
66 gate control circuit
67 IGBT gate terminal
68 gate-control-diode gate terminal
69 emitter sense terminal
70 zero bias or positive bias
71 negative bias lower than threshold voltage
72 forward-direction external power source
73 hole layer
74 hole carrier
75 electron carrier
76 electron layer
77 P-type anode layer
78 ohmic contact (barrier)
81 gate electrode
82 gate insulating film (gate oxide film)
83 insulation gate (gate)
84 P-type anode layer
85 N-type well layer
86 anode electrode
87 N-type cathode drift layer
88 N+ cathode layer
89 cathode electrode
90 neutral point
91 IGBT
92 upper arm
93 gate control diode
94 lower arm
95 inductive load
96 upper arm or lower arm
97 gate control signal of upper-arm IGBT
98 gate control signal of upper-arm gate control diode
99 cathode-anode voltage V_{KA} of upper-arm gate control diode
100 cathode current I_{K} of upper-arm gate control diode
101 gate control signal of lower-arm IGBT
102 gate control signal of lower-arm gate control diode
103 collector-emitter voltage V_{CE} of lower-arm IGBT
104 collector current I_{C} of lower-arm IGBT
105 conduction duration of lower-arm IGBT
106 conduction duration of upper-arm gate control diode
107 current flowing through diode
108 cathode-anode voltage
109 duration in which diode is in conduction state, conduction duration
110 duration in which diode is in reverse recovery state, reverse recovery duration
111 duration in which diode is in opposite direction bias state, non-conduction duration
112 negative bias lower than threshold voltage
113 positive bias equal to or higher than threshold voltage
115 collector-emitter voltage V_{CE} of upper-arm IGBT
116 collector current I_{C} of upper-arm IGBT
117 cathode-anode voltage V_{KA} of lower-arm gate control diode
118 cathode current I_{K} of lower-arm gate control diode
119 conduction duration of lower-arm gate control diode
120 conduction duration of upper-arm IGBT
121 neutral point of three-phase alternating-current inverter
122 neutral point of three-phase alternating-current inverter
123 neutral point of three-phase alternating-current inverter
130 single-phase alternating-current inverter (Figure 2)
140 circuit (Figure 10) of inverter in which gate control circuit and arm are coupled
150 single-phase alternating-current inverter (Figure 12)
160 circuit (Figure 15) of inverter in which gate control circuit and arm are coupled
164 control circuit
167 control circuit that controls IGBT gate
168 inductive load
169 direct-current voltage (electric power) source
170 IGBT
171 insulation gate (terminal) of IGBT 70
172 diode coupled to IGBT 70 in antiparallel
200, 200' method of Example 1
201 method of comparative example for Example 1
203 gate control diode
300, 300' method of Example 2
400 method of Example 3, case in which g with long "on" command duration is input
401 method of Example 3, case in which f with short "on" command duration is input
500 three-phase alternating-current inverter
501 modification of three-phase alternating-current inverter
600 three-phase alternating-current inverter (Figure 20)
700 evaluation circuit (Figure 21)
901 dual-gate IGBT
902 gate control circuit
950 motor
951 command unit of three-phase alternating-current inverter
T time

## Claims

1. A semiconductor-circuit control method of controlling a semiconductor circuit including paired arms (92,94) in each of which a gate control diode (93) is coupled to an IGBT (91) and that are coupled in series, wherein
in each of the arms, a conduction direction through a collector and an emitter of the IGBT (91) and a conduction direction through an anode (86) and a cathode (89) of the gate control diode (93) are coupled in antiparallel,
the gate control diode (93) and the IGBT (91) in one of the paired arms (92,94) are coupled in series to the gate control diode (93) and the IGBT (91), respectively, in the other paired arm, and
in the gate control diode (93),
an anode electrode (86), a cathode electrode (89), and a gate electrode (81) are provided on a semiconductor substrate and insulated from one another,
carrier concentration of a drift area (87) in the semiconductor substrate is controlled in accordance with voltage applied to the gate electrode (81),
in a forward recovery state (23) of the gate control diode occurring upon turn-off of a gate control signal (1) of the IGBT (91) disposed in the same paired arm (92, 94) as the gate control diode (93), a voltage signal of negative bias (12) with which a hole layer (73) is generated at an interface of the gate electrode (81) is applied between the gate electrode (81) and the anode electrode (86),
in a reverse recovery state (24) of the gate control diode occurring upon turn-on of the gate control signal (1) of the IGBT (91) disposed in the same paired arm (92, 94) as the gate control diode (93), a voltage signal of zero bias or positive bias (11) with which an electron layer is generated at the interface of the gate electrode (81) is applied between the gate electrode (81) and the anode electrode (86),
after the forward recovery state of the gate control diode (23), the voltage signal of negative bias (12) is switched to the voltage signal for applying the zero bias or the positive bias (11),
after the reverse recovery state (24) of the gate control diode, the voltage signal of zero bias or positive bias (11) is switched to the voltage signal for applying the negative bias (12), and
a duration of application of the zero bias or the positive bias (11) is controlled to vary in accordance with a non-conduction duration (19) of the IGBTs (91) coupled in series so that the pulse width of the paired other arm is determined in accordance with the pulse width of the one paired arm, **characterized in that**
the non-conduction duration (19) of the IGBTs (91) coupled in series is denoted by t_{off},
as for a state of the gate control diode (93),
a duration in which the reverse recovery state (24) is reached after the zero bias or the positive bias (11) is applied between the gate electrode (81) and the anode electrode (86) is denoted by t_{d_rr}, and
a duration of the forward recovery state (23) is denoted by t_{fr}, and
a duration t_{d_rr} in which the reverse recovery state (24) is reached is controlled to vary in accordance with the length of the non-conduction duration (19) t_{off} so that the non-conduction duration (19) t_{off} and a duration t_{d_rr} + t_{fr} as the sum of the duration t_{d_rr} in which the reverse recovery state (24) is reached and the duration t_{fr} of the forward recovery state (23) satisfy a relation t_{off} ≥ t_{d_rr} + t_{fr}.

2. The semiconductor-circuit control method according to claim 1, wherein
a fixed duration that does not depend on the non-conduction duration (19) t_{off} is denoted by b,
the fixed duration "b" is the duration t_{d_rr} in which the recovery state is reached when the non-conduction duration (19) t_{off} satisfies a relation t_{off} > b + t_{fr}, and
the duration t_{d_rr} in which the recovery state is reached is controlled to vary in accordance with the non-conduction duration (19) t_{off}.

3. The semiconductor-circuit control method according to claim 2, wherein
a semiconductor circuit including
a first IGBT (91,901) of the IGBTs, the first IGBT (91, 901) being disposed in the one paired arm (92,94),
a second IGBT (91,901) of the IGBTs, the second IGBT (91, 901) being disposed in the second paired arm (92,94), and
the gate control diode (93,203) coupled in series to the first IGBT (91,901)
is used,
a first gate terminal (67A) is a terminal capable of applying voltage between a gate electrode (81) and an emitter electrode (69) of the first IGBT (91,901),
a second gate terminal (67B) is a terminal capable of applying voltage between a gate electrode (81) and an emitter electrode (69) of the second IGBT (91,901),
a voltage signal with which the first IGBT (91,901) and the second IGBT (91,901) are controlled to complementary conduct or not conduct at a constant interval and that is based on a first PWM command signal (63) and a second PWM command signal (64) having modulated pulse widths is input to the first gate terminal (67A) and the second gate terminal (67B), and
a voltage signal applied between the gate electrode (81) and the anode electrode (86) of the gate control diode (93,203) is generated based on the second PWM command signal (64).

4. The semiconductor-circuit control method according to claim 3, wherein a voltage signal applied to the second gate terminal (67B) and the voltage signal applied between the gate electrode (81) and the anode electrode (86) of the gate control diode (93,203) are generated at the same gate control circuit board (66) upon reception of the second PWM command signal (64).

5. The semiconductor-circuit control method according to claim 4, wherein a timing of switching the voltage signal applied between the gate electrode (81) and the anode electrode (86) of the gate control diode (93,203) is generated by delaying the second PWM command signal (64) by a constant duration at the gate control circuit board and calculating logical conjunction of a PWM trigger signal synchronized with the pulse width of the second PWM command signal (64) and a fixed trigger signal having a conduction command duration longer than the fixed duration "b".

6. The semiconductor-circuit control method according to claim 5, wherein falling timings of pulses of the PWM trigger signal and the fixed trigger signal are delayed until the reverse recovery state (24) of the gate control diode (93,203) elapses.

7. The semiconductor-circuit control method according to claim 6, wherein
voltage signals delayed from the first PWM command signal (63) and the second PWM command signal (64) by the same constant duration "a" are input to the first gate terminal (67A) and the second gate terminal (67B), respectively,
when DT represents an interval duration between conduction command signals in the first PWM command signal (63) and the second PWM command signal (64), the fixed duration "b", the constant duration "a", and the interval duration DT have a relation b = a + DT, and
at falling timings of pulses of the second PWM command signal (64), an "on" command is input for the fixed trigger signal having a conduction command duration longer than the fixed duration "b".

8. An electric power converter to which the semiconductor-circuit control method according to any one of claims 1 to 7 is applied, wherein
the gate control diode (93) includes
the semiconductor substrate of a first conduction type,
a cathode area that is of the first conduction type and provided on a first surface side of the semiconductor substrate,
an anode area that is of a second conduction type and provided on a second surface side opposite to the first surface side of the semiconductor substrate,
an anode electrode (86) disposed on the second surface side of the anode area, and
a gate electrode (81) adjacent to the anode area through a gate insulating film (82),
in the gate electrode (81), inside of a trench extending from the second surface side to the cathode area through the anode area is surrounded by the gate insulating film (82),
the anode area contacts a well area (85) that is of the first conduction type and contacts the gate insulating film (82),
the well area (85) is adjacent to a drift area (87) that is of the first conduction type and contacts the cathode area,
a hole layer (73) is formed at part of the well area (85), the part contacting the gate insulating film (82), when the negative bias (12) is applied to the gate electrode (81) with respect to the anode electrode (86), and
in the forward recovery state (23), holes are injected from the hole layer (73) formed in the well area (85) into the drift area (87).

9. The electric power converter according to claim 8, wherein each of the IGBTs (91)
is a dual-gate IGBT (901) including the first gate terminal (67A) and the second gate terminal (67B), and
has a control function
to transition from a non-conduction state (27) to a conduction state (28) when a voltage equal to or higher than a threshold value is applied to at least one of the gate terminals, and
to transition from the conduction state (28) to the non-conduction state (27) when voltages applied to the two gate terminals are both lower than the threshold value.

10. The electric power converter according to claim 8 or 9, wherein
to convert direct current into single-phase or three-phase alternating current and supply electric power to a load (950), a circuit configuration includes the paired arms (92,94) of pairs in a number in accordance with the number of phases of the alternating current obtained through the conversion,
one end and the other end of each of the paired arms (92,94) are input terminals coupled to positivity and negativity, respectively, for the direct current, and
a neutral point (121,122,123) coupling the paired arms (92,94) of each of the pairs in a number in accordance with the number of phases is an alternating-current terminal (121,122,123) coupled to the load (950).

## Patentansprüche

1. Halbleiterschaltungssteuerungsverfahren zum Steuern einer Halbleiterschaltung, die gepaarte Zweige (92, 94) beinhaltet, in denen jeweils eine Gate-Steuerdiode (93) mit einem IGBT (91) gekoppelt ist und die in Serie gekoppelt sind, wobei
in jedem der Zweige eine Durchlassrichtung durch einen Kollektor und einen Emitter des IGBT (91) und eine Durchlassrichtung durch eine Anode (86) und eine Kathode (89) der Gate-Steuerdiode (93) antiparallel gekoppelt sind,
die Gate-Steuerdiode (93) und der IGBT (91) in einem aus den gepaarten Zweigen (92, 94) jeweils mit der Gate-Steuerdiode (93) und dem IGBT (91) in dem anderen gepaarten Zweig in Serie gekoppelt sind, und wobei
in der Gate-Steuerdiode (93)
eine Anodenelektrode (86), eine Kathodenelektrode (89) und eine Gate-Elektrode (81) auf einem Halbleitersubstrat bereitgestellt und voneinander isoliert sind,
die Trägerkonzentration eines Drift-Bereichs (87) im Halbleitersubstrat entsprechend einer an die Gate-Elektrode (81) angelegten Spannung gesteuert wird,
in einem Durchlasserholungszustand (23) der Gate-Steuerdiode, der beim Ausschalten eines Gate-Steuersignals (1) des IGBT (91), der in demselben gepaarten Zweig (92, 94) wie die Gate-Steuerdiode (93) angeordnet ist, eintritt, ein Spannungssignal negativer Vorspannung (12), mit der eine Lochschicht (73) an einer Grenzfläche der Gate-Elektrode (81) erzeugt wird, zwischen der Gate-Elektrode (81) und der Anodenelektrode (86) angelegt wird,
in einem Sperrerholungszustand (24) der Gate-Steuerdiode, der beim Einschalten des Gate-Steuersignals (1) des IGBT (91), der in demselben gepaarten Zweig (92, 94) wie die Gate-Steuerdiode (93) angeordnet ist, ein Spannungssignal von Null-Vorspannung oder positiver Vorspannung (11), mit der eine Elektronenschicht an der Grenzfläche der Gate-Elektrode (81) erzeugt wird, zwischen der Gate-Elektrode (81) und der Anodenelektrode (86) angelegt wird,
nach dem Durchlasserholungszustand der Gate-Steuerdiode (23) das Spannungssignal negativer Vorspannung (12) auf das Spannungssignal zum Anlegen der Nullvorspannung oder der positiven Vorspannung (11) umgeschaltet wird,
nach dem Sperrerholungszustand (24) der Gate-Steuerdiode das Spannungssignal der Nullvorspannung oder der positiven Vorspannung (11) auf das Spannungssignal zum Anlegen der negativen Vorspannung (12) umgeschaltet wird, und
eine Dauer des Anlegens der Nullvorspannung oder der positiven Vorspannung (11) derart gesteuert wird, dass sie entsprechend einer Nichtdurchlassdauer (19) der in Serie gekoppelten IGBTs (91) variiert, sodass die Pulsbreite des anderen gepaarten Zweigs entsprechend der Pulsbreite des einen gepaarten Zweigs bestimmt wird, **dadurch gekennzeichnet, dass**
die Nichtdurchlassdauer (19) der in Serie gekoppelten IGBTs (91) als t_{off} bezeichnet wird,
betreffend einen Zustand der Gate-Steuerdiode (93)
eine Dauer, in der der Sperrerholungszustand (24) erreicht wird, nachdem die Nullvorspannung oder die positive Vorspannung (11) zwischen der Gate-Elektrode (81) und der Anodenelektrode (86) angelegt wurde, als t_{d_rr} bezeichnet wird, und
eine Dauer des Durchlasserholungszustands (23) durch t_{fr} bezeichnet wird, und
eine Dauer t_{d_rr}, in welcher der Sperrerholungszustand (24) erreicht wird, derart gesteuert wird, dass sie entsprechend der Länge der Nichtdurchlassdauer (19) t_{off} variiert, sodass die Nichtdurchlassdauer (19) t_{off} und eine Dauer t_{d_rr} + t_{fr} als Summe der Dauer t_{d_rr}, in welcher der Sperrerholungszustand (24) erreicht wird, und die Dauer t_{fr} des Durchlasserholungszustands (23) die Beziehung t_{off} ≥ t_{d_rr} + t_{fr} erfüllen.

2. Halbleiterschaltungssteuerungsverfahren nach Anspruch 1, wobei
eine festgelegte Dauer, die nicht von der Nichtdurchlassdauer (19) t_{off} abhängig ist, als b bezeichnet wird,
die festgelegte Dauer "b" die Dauer t_{d_rr} ist, in welcher der Erholungszustand erreicht wird, wenn die Nichtdurchlassdauer (19) t_{off} die Beziehung t_{off} > b + t_{fr} erfüllt, und
die Dauer t_{d_rr}, in welcher der Erholungszustand erreicht wird, derart gesteuert wird, dass sie entsprechend der Nichtdurchlassdauer (19) t_{off} variiert.

3. Halbleiterschaltungssteuerungsverfahren nach Anspruch 2, wobei
eine Halbleiterschaltung verwendet wird, die Folgendes umfasst:
einen ersten IGBT (91, 901) aus den IGBTs, wobei der erste IGBT (91, 901) in dem einen gepaarten Zweig (92, 94) angeordnet ist,
einen zweiten IGBT (91, 901) aus den IGBTs, wobei der zweite IGBT (91, 901) in dem zweiten gepaarten Zweig (92, 94) angeordnet ist, und
die Gate-Steuerdiode (93, 203), die in Serie mit dem ersten IGBT (91, 901) gekoppelt ist, wobei
ein erster Gate-Anschluss (67A) ein Anschluss ist, der in der Lage ist, Spannung zwischen einer Gate-Elektrode (81) und einer Emitterelektrode (69) des ersten IGBT (91, 901) anzulegen,
ein zweiter Gate-Anschluss (67B) ein Anschluss ist, der in der Lage ist, Spannung zwischen einer Gate-Elektrode (81) und einer Emitterelektrode (69) des zweiten IGBT (91, 901) anzulegen,
ein Spannungssignal, mit dem der erste IGBT (91, 901) und der zweite IGBT (91, 901) derart gesteuert werden, dass sie in einem konstanten Intervall komplementär leiten oder nicht leiten, und das auf einem ersten PWM-Befehlssignal (63) und einem zweiten PWM-Befehlssignal (64) mit modulierten Pulsbreiten beruht, in den ersten Gate-Anschluss (67A) und den zweiten Gate-Anschluss (67B) eingegeben wird, und
ein Spannungssignal, das zwischen der Gate-Elektrode (81) und der Anodenelektrode (86) der Gate-Steuerdiode (92, 203) angelegt wird, beruhend auf dem zweiten PWM-Befehlssignal (64) erzeugt wird.

4. Halbleiterschaltungssteuerungsverfahren nach Anspruch 3, wobei ein an den zweiten Gate-Anschluss (67B) angelegtes Spannungssignal und das zwischen der Gate-Elektrode (81) und der Anodenelektrode (86) der Gate-Steuerdiode (93, 203) angelegte Spannungssignal bei Empfang des zweiten PWM-Befehlssignals (64) in derselben Gate-Steuerplatine (66) erzeugt werden.

5. Halbleiterschaltungssteuerungsverfahren nach Anspruch 4, wobei eine Zeitgebung des Umschaltens des zwischen der Gate-Elektrode (81) und der Anodenelektrode (86) der Gate-Steuerdiode (93, 203) angelegten Spannungssignals durch Verzögern des zweiten PWM-Befehlssignals (64) um eine konstante Dauer in der Gate-Steuerplatine und durch Berechnen der logischen Konjunktion eines PWM-Triggersignals, das mit der Pulsbreite des zweiten PWM-Befehlssignals (64) synchronisiert ist, und eines festgelegten Triggersignals, das eine Durchlassbefehlsdauer, die länger ist als die festgelegte Dauer "b", aufweist, erzeugt wird.

6. Halbleiterschaltungssteuerungsverfahren nach Anspruch 5, wobei nachlassende Zeitgebungen von Pulsen des PWM-Triggersignals und des festgelegten Triggersignals verzögert werden, bis der Sperrerholungszustand (24) der Gate-Steuerdiode (93, 203) abläuft.

7. Halbleiterschaltungssteuerungsverfahren nach Anspruch 6, wobei
Spannungssignale, die von dem ersten PWM-Befehlssignal (63) und dem zweiten PWM-Befehlssignal (64) um die gleiche konstante Dauer "a" verzögert sind, jeweils in den ersten Gate-Anschluss (67A) und den zweiten Gate-Anschluss (67B) eingegeben werden,
wenn DT für eine Intervalldauer zwischen Durchlassbefehlssignalen in dem ersten PWM-Befehlssignal (63) und dem zweiten PWM-Befehlssignal (64) steht, die festgelegte Dauer "b", die konstante Dauer "a" und die Intervalldauer DT eine Beziehung b = a + DT aufweisen, und
bei nachlassenden Zeitgebungen von Pulsen des zweiten PWM-Befehlssignals (64) ein "Ein"-Befehl für das festgelegte Triggersignal eingegeben wird, das eine Durchlassbefehlsdauer aufweist, die länger als die festgelegte Dauer "b" ist.

8. Elektrischer Leistungswandler, auf den ein Halbleiterschaltungssteuerungsverfahren nach einem der Ansprüche 1 bis 7 angewendet wird, wobei
die Gate-Steuerdiode (93) Folgendes beinhaltet:
das Halbleitersubstrat von einem ersten Leitungstyp;
einen Kathodenbereich, der von dem ersten Leitungstyp ist und auf einer ersten Oberflächenseite des Halbleitersubstrats bereitgestellt ist,
einen Anodenbereich, der von einem zweiten Leitungstyp ist und auf einer zweiten Oberflächenseite entgegengesetzt zu der ersten Oberflächenseite des Halbleitersubstrats angeordnet ist,
eine Anodenelektrode (86), die auf der zweiten Oberflächenseite des Anodenbereichs angeordnet ist, und
eine Gate-Elektrode (81), die über einen Gate-Isolierfilm (82) benachbart zu dem Anodenbereich angeordnet ist,
wobei die Gate-Elektrode (81), innerhalb eines Grabens, der sich von der zweiten Oberflächenseite über den Anodenbereich zu dem Kathodenbereich erstreckt, von dem Gate-Isolierfilm (82) umgeben ist, wobei
der Anodenbereich einen Well-Bereich (85) kontaktiert, der vom ersten Leitungstyp ist und den Gate-Isolierfilm (82) kontaktiert,
der Well-Bereich (85) benachbart zu einem Drift-Bereich (87) ist, der vom ersten Leitungstyp ist und den Kathodenbereich kontaktiert,
eine Lochschicht (73) in einem Teil des Well-Bereichs (85) ausgebildet ist, wobei der Teil den Gate-Isolierfilm (82) kontaktiert, wenn die negative Vorspannung (12) an die Gate-Elektrode (81) in Bezug auf die Anodenelektrode (86) angelegt wird, und
im Durchlasserholungszustand (23) Löcher von der Lochschicht (73), die in dem Well-Bereich (85) ausgebildet ist, in den Drift-Bereich (87) injiziert werden.

9. Elektrischer Leistungswandler nach Anspruch 8, wobei jeder aus den IGBTs (91)
ein Dual-Gate-IGBT (901) ist, der den ersten Gate-Anschluss (67A) und den zweiten Gate-Anschluss (67B) beinhaltet, und
eine Steuerfunktion aufweist,
um von einem Nichtdurchlasszustand (27) zu einem Durchlasszustand (28) überzugehen, wenn eine Spannung gleich oder höher als ein Schwellenwert an zumindest einen aus den Gate-Anschlüssen angelegt wird, und
um von dem Durchlasszustand (28) zu dem Nichtdurchlasszustand (27) überzugehen, wenn an die zwei Gate-Anschlüsse angelegte Spannungen beide niedriger als der Schwellenwert sind.

10. Elektrischer Leistungswandler nach Anspruch 8 oder 9, wobei
beim Umwandeln von Gleichstrom zu Einphasen- oder Dreiphasen-Wechselstrom und Zuführen von elektrischer Leistung zu einer Last (950) eine Schaltungskonfiguration die gepaarten Zweige (92, 94) aus Paaren in einer Anzahl entsprechend der Anzahl von Phasen des Wechselstroms, die durch die Umwandlung erhalten wurden, beinhaltet,
ein Ende und das andere Ende von jedem aus den gepaarten Zweigen (92, 94) Eingangsanschlüsse, die jeweils mit Positivität und Negativität gekoppelt sind, für den Gleichstrom sind, und
ein neutraler Punkt (121, 122, 123), welcher die gepaarten Zweige (92, 94) von jedem aus den Paaren in einer Anzahl entsprechend der Anzahl von Phasen koppelt, ein mit der Last (950) gekoppelter Wechselstromanschluss (121, 122, 123) ist.

## Revendications

1. Procédé de commande de circuit semi-conducteur qui consiste à commander un circuit semi-conducteur comportant des bras jumelés (92, 94) dans chacun desquels une diode de commande de gâchette (93) est couplée à un transistor bipolaire à gâchette isolée (91) et qui sont couplés en série, dans lequel
dans chacun des bras, une direction de conduction à travers un collecteur et un émetteur du transistor bipolaire à gâchette isolée (91) et une direction de conduction à travers une anode (86) et une cathode (89) de la diode de commande de gâchette (93) sont couplées en antiparallèle,
la diode de commande de gâchette (93) et le transistor bipolaire à gâchette isolée (91) dans l'un des bras jumelés (92, 94) sont couplés en série à la diode de commande de gâchette (93) et au transistor bipolaire à gâchette isolée (91), respectivement, dans l'autre bras jumelé, et
dans la diode de commande de gâchette (93),
une électrode d'anode (86), une électrode de cathode (89) et une électrode de gâchette (81) sont prévues sur un substrat semi-conducteur et isolées les unes des autres,
la concentration de porteurs d'une zone de dérive (87) dans le substrat semi-conducteur est contrôlée selon la tension appliquée à l'électrode de gâchette (81),
dans un état de récupération par progression (23) de la diode de commande de gâchette qui se produit lors de la désactivation d'un signal de commande de gâchette (1) du transistor bipolaire à gâchette isolée (91) disposé dans le même bras jumelé (92, 94) que la diode de commande de gâchette (93), un signal de tension à polarisation négative (12) avec lequel une couche d'orifices (73) est générée au niveau d'une interface de l'électrode de gâchette (81) est appliqué entre l'électrode de gâchette (81) et l'électrode d'anode (86),
dans un état de récupération inverse (24) de la diode de commande de gâchette qui se produit lors de l'activation du signal de commande de gâchette (1) du transistor bipolaire à gâchette isolée (91) disposé dans le même bras jumelé (92, 94) que la diode de commande de gâchette (93), un signal de tension à polarisation nulle ou à polarisation positive (11) avec lequel une couche d'électrons est générée au niveau de l'interface de l'électrode de gâchette (81) est appliqué entre l'électrode de gâchette (81) et l'électrode d'anode (86),
après l'état de récupération par progression de la diode de commande de gâchette (23), le signal de tension à polarisation négative (12) est basculé vers le signal de tension destiné à appliquer la polarisation nulle ou la polarisation positive (11),
après l'état de récupération inverse (24) de la diode de commande de gâchette, le signal de tension à polarisation nulle ou à polarisation positive (11) est basculé vers le signal de tension destiné à appliquer la polarisation négative (12), et
une durée d'application de la polarisation nulle ou de la polarisation positive (11) est contrôlée afin de varier selon une durée de non-conduction (19) des transistors bipolaires à gâchette isolée (91) couplés en série de sorte que la durée d'impulsion de l'autre bras jumelé soit déterminée selon la durée d'impulsion du bras jumelé, **caractérisé en ce que**
la durée de non-conduction (19) des transistors bipolaires à gâchette isolée (91) couplés en série est indiquée par t_{off},
quant à un état de la diode de commande de gâchette (93), une durée pendant laquelle l'état de récupération inverse (24) est atteint après que la polarisation nulle ou la polarisation positive (11) a été appliquée entre l'électrode de gâchette (81) et l'électrode d'anode (86) est indiquée par t_{d_rr}, et
une durée de l'état de récupération par progression (23) est indiquée par t_{fr}, et
une durée t_{d_rr} pendant laquelle l'état de récupération inverse (24) est atteint est contrôlée afin de varier selon la longueur de la durée de non-conduction (19) t_{off} de sorte que la durée de non-conduction (19) t_{off} et une durée t_{d_rr} + t_{fr} sous forme de somme de la durée t_{d_rr} pendant laquelle l'état de récupération inverse (24) est atteint et de la durée t_{fr} de l'état de récupération par progression (23) satisfassent une relation t_{off} ≥ t_{d_rr} + t_{fr}.

2. Procédé de commande de circuit semi-conducteur selon la revendication 1, dans lequel
une durée fixe qui ne dépend pas de la durée de non-conduction (19) t_{off} est indiquée par b,
la durée fixe « b » est la durée t_{d_rr} pendant laquelle l'état de récupération est atteint lorsque la durée de non-conduction (19) t_{off} satisfait une relation t_{off} > b + t_{fr}, et
la durée t_{d_rr} pendant laquelle l'état de récupération est atteint est contrôlée afin de varier selon la durée de non-conduction (19) t_{off}.

3. Procédé de commande de circuit semi-conducteur selon la revendication 2, dans lequel
un circuit semi-conducteur comportant
un premier transistor bipolaire à gâchette isolée (91, 901) des transistors bipolaires à gâchette isolée, le premier transistor bipolaire à gâchette isolée (91, 901) étant disposé dans le bras jumelé (92, 94),
un deuxième transistor bipolaire à gâchette isolée (91, 901) des transistors bipolaires à gâchette isolée, le deuxième transistor bipolaire à gâchette isolée (91, 901) étant disposé dans le deuxième bras jumelé (92, 94), et
la diode de commande de gâchette (93, 203) couplée en série au premier transistor bipolaire à gâchette isolée (91, 901)
est utilisé,
une première borne de gâchette (67A) est une borne capable d'appliquer une tension entre une électrode de gâchette (81) et une électrode d'émetteur (69) du premier transistor bipolaire à grille isolée (91, 901),
une deuxième borne de gâchette (67B) est une borne capable d'appliquer une tension entre une électrode de gâchette (81) et une électrode d'émetteur (69) du deuxième transistor bipolaire à grille isolée (91, 901),
un signal de tension avec lequel le premier transistor bipolaire à grille isolée (91, 901) et le deuxième transistor bipolaire à grille isolée (91, 901) sont commandés afin d'être conducteurs ou non-conducteurs de manière complémentaire à un intervalle constant et qui repose sur un premier signal de commande à modulation de durée d'impulsion (63) et un deuxième signal de commande à modulation de durée d'impulsion (64) ayant des durées d'impulsion modulées est fourni à la première borne de gâchette (67A) et à la deuxième borne de gâchette (67B), et
un signal de tension appliqué entre l'électrode de gâchette (81) et l'électrode d'anode (86) de la diode de commande de gâchette (93, 203) est généré sur la base du deuxième signal de commande à modulation de durée d'impulsion (64).

4. Procédé de commande de circuit semi-conducteur selon la revendication 3, dans lequel un signal de tension appliqué à la deuxième borne de gâchette (67B) et le signal de tension appliqué entre l'électrode de gâchette (81) et l'électrode d'anode (86) de la diode de commande de gâchette (93, 203) sont générés au niveau de la même carte de circuit de commande de gâchette (66) lors de la réception du deuxième signal de commande à modulation de durée d'impulsion (64).

5. Procédé de commande de circuit semi-conducteur selon la revendication 4, dans lequel un moment de déclenchement du signal de tension appliqué entre l'électrode de gâchette (81) et l'électrode d'anode (86) de la diode de commande de gâchette (93, 203) est généré en retardant le deuxième signal de commande à modulation de durée d'impulsion (64) selon une durée constante au niveau de la carte de circuit de commande de gâchette et en calculant la conjonction logique d'un signal de déclenchement à modulation de durée d'impulsion synchronisé avec la durée d'impulsion du deuxième signal de commande à modulation de durée d'impulsion (64) et d'un signal de déclenchement fixe ayant une durée de commande de conduction supérieure à la durée fixe « b ».

6. Procédé de commande de circuit semi-conducteur selon la revendication 5, dans lequel les temps de chute des impulsions du signal de déclenchement à modulation de durée d'impulsion et du signal de déclenchement fixe sont retardés jusqu'à ce que l'état de récupération inverse (24) de la diode de commande de gâchette (93, 203) passe.

7. Procédé de commande de circuit semi-conducteur selon la revendication 6, dans lequel
les signaux de tension retardés par rapport au premier signal de commande à modulation de durée d'impulsion (63) et au deuxième signal de commande à modulation de durée d'impulsion (64) selon la même durée constante « a » sont fournis à la première borne de gâchette (67A) et à la deuxième borne de gâchette (67B), respectivement,
lorsque DT représente une durée d'intervalle entre les signaux de commande de conduction dans le premier signal de commande à modulation de durée d'impulsion (63) et le deuxième signal de commande à modulation de durée d'impulsion (64), la durée fixe « b », la durée constante « a » et la durée d'intervalle DT présentent une relation b = a + DT, et
aux temps de chute des impulsions du deuxième signal de commande à modulation de durée d'impulsion (64), une commande « on » est fournie pour le signal de déclenchement fixe ayant une durée de commande de conduction supérieure à la durée fixe « b ».

8. Convertisseur électrique de puissance auquel le procédé de commande de circuit semi-conducteur selon l'une quelconque des revendications 1 à 7 est appliqué, dans lequel
la diode de commande de gâchette (93) comporte
le substrat semi-conducteur d'un premier type de conduction,
une zone de cathode qui est du premier type de conduction et prévue sur une première surface du substrat semi-conducteur,
une zone d'anode qui est d'un deuxième type de conduction et prévue sur une deuxième surface opposée à la première surface du substrat semi-conducteur,
une électrode d'anode (86) disposée sur la deuxième surface de la zone d'anode, et
une électrode de gâchette (81) adjacente à la zone d'anode à travers un film d'isolation de gâchette (82),
dans l'électrode de gâchette (81), l'intérieur d'une tranchée qui s'étend de la deuxième surface vers la zone de cathode en passant par la zone d'anode est entouré par le film d'isolation de gâchette (82),
la zone d'anode est en contact avec une zone de puits (85) qui est du premier type de conduction et est en contact avec le film d'isolation de gâchette (82),
la zone de puits (85) est adjacente à une zone de dérive (87) qui est du premier type de conduction et est en contact avec la zone de cathode,
une couche d'orifices (73) est formée au niveau d'une partie de la zone de puits (85), la partie étant en contact avec le film d'isolation de gâchette (82), lorsque la polarisation négative (12) est appliquée à l'électrode de gâchette (81) par rapport à l'électrode d'anode (86), et
dans l'état de récupération par progression (23), les orifices sont injectés depuis la couche d'orifices (73) formée dans la zone de puits (85), vers la zone de dérive (87).

9. Convertisseur électrique de puissance selon la revendication 8, dans lequel chacun des transistors bipolaires à gâchette isolée (91)
est un transistor bipolaire à gâchette isolée à deux grilles (901) comportant la première borne de gâchette (67A) et la deuxième borne de gâchette (67B), et
possède une fonction de commande
afin de passer d'un état de non-conduction (27) à un état de conduction (28) lorsqu'une tension égale ou supérieure à une valeur de seuil est appliquée à au moins l'une des bornes de gâchette, et
afin de passer de l'état de conduction (28) à l'état de non-conduction (27) lorsque les tensions appliquées aux deux bornes de gâchette sont toutes deux inférieures à la valeur de seuil.

10. Convertisseur électrique de puissance selon la revendication 8 ou 9, dans lequel
afin de convertir un courant continu en courant alternatif monophasé ou triphasé et de fournir de l'électricité à une charge (950), une configuration de circuit comporte les bras jumelés (92, 94) sous forme de paires dans un nombre qui correspond au nombre de phases du courant alternatif obtenu par le biais de la conversion,
une extrémité et l'autre extrémité de chacun des bras jumelés (92, 94) sont des bornes d'entrée couplées à une positivité et une négativité, respectivement, pour le courant continu, et
un point neutre (121, 122, 123) qui couple les bras jumelés (92, 94) de chacune des paires dans un nombre qui correspond au nombre de phases est une borne de courant alternatif (121, 122, 123) couplée à la charge (950).
